# EUROPEAN PATENT SPECIFICATION

(11) **EP 2 033 229 B1**
(45) Date of publication and mention of the grant of the patent: **04.07.2012**
(21) Application number: 07798784.0
(22) Date of filing: 19.06.2007
(51) Int. Cl.: H01L 31/0224

(54) **PHOTOVOLTAIC CONDUCTIVE FEATURES AND PROCESSES FOR FORMING SAME**
PHOTOVOLTAISCHE LEITFÄHIGE ELEMENTE UND HERSTELLUNGSVERFAHREN DAFÜR
CARACTÉRISTIQUES CONDUCTRICES PHOTOVOLTAÏQUES ET PROCÉDÉ DE FORMATION DE CES DERNIÈRES

(30) Priority: 19.06.2006 US 805185 P
(43) Date of publication of application: 11.03.2009
(73) Proprietor: Cabot Corporation, Boston, MA 02210 (US)
(72) Inventor: KODAS, Toivo T., Carlisle, MA 01741 (US); OLJACA, Miodrag, Albuquerque, NM 87111 (US); HAMPDEN-SMITH, Mark J., Albuquerque, NM 87107 (US); FOTOU, George P., Albuquerque, NM 87120 (US); KIM, Hyungrak, Saratoga, CA 95070 (US); KOWALSKI, Mark H., Albuquerque, NM 87122 (US)
(74) Representative: Serravalle, Marco
(86) International application number: PCT/US2007/071599
(87) International publication number: WO 2007/149883

(56) References cited:
- EP-A- 1 244 168
- EP-A- 1 300 897
- FR-A- 2 862 429
- US-B1- 6 582 763
- NORTON D P: "Synthesis and properties of epitaxial electronic oxide thin-film materials" MATERIALS SCIENCE AND ENGINEERING R: REPORTS, ELSEVIER SEQUOIA S.A., LAUSANNE, CH, vol. 43, no. 5-6, 15 March 2004 (2004-03-15), pages 139-247, XP004490876 ISSN: 0927-796X

## Description

### Field

This invention relates to metal-containing nanoparticles, their synthesis and their use in the formation of photovoltaic conductive features, such as those used in solar cells.

### Background

Improvement in solar cell efficiency can have a significant impact in the broad market adoption of solar cell technology. It is possible, for example, that a 0.2% cell efficiency improvement derived from improved performance of front grid electrodes for solar cells could lead to as much as $250M cost savings for the solar cell manufacturing market in 2010.

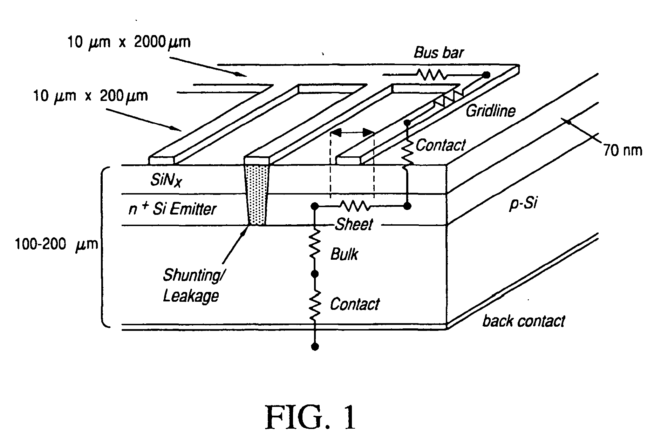

The major contributors to the limitations on solar cell efficiency are the contact resistance and the line resistance in the front grid electrodes. A portion of a typical solar cell is depicted schematically in FIG. 1. A typical method for forming front grid electrodes for solar cells is screen printing. Under known screen printing methods for forming front grid electrodes, high contact resistance arises as a result of the processing conditions of the solar cell after a screen printing paste is applied to the passivating layer of a solar cell. The passivating layer often comprises silicon nitride. Typical screen printing pastes comprise more than 5 wt% micron-sized lead glass particles and on the order of 75 wt% micron-sized silver particles. The glass particles etch the silicon nitride layer at the emitter/electrode interface at high processing temperatures (e.g., > 800°C). Etching of the silicon nitride layer is necessary to achieve a satisfactory contact between the electrode and the emitter surface (e.g., the surface of an n-type semiconductor). At such high temperatures, however, the diffusion rate of silver in the silicon emitter layer of the solar cell is high and complete etching of the n-type semiconductor layer undesirably can result. Complete etching of the n-type semiconductor layer is undesirable since the silver can cause shunting of the cell.

In addition, when screen printing is used to form the front grid electrodes, high line resistance arises as a result of the amount of lead glass present in the bulk electrode layer. Because the lead glass particle are relatively large (in the micron size range), the glass particles have relatively low reactivity and do not sinter to form a dense body under the processing conditions described above. The presence of unsintered glass particles in the bulk electrode layer leads to high porosity in that layer. Porosity in the bulk electrode layer, in turn, leads to high line resistance in the bulk electrode layer.

Documents EP 1244168A and US6,582,763B1 describe networks of coated metal particles.

While screen printing is an inexpensive and fast method for printing front grid electrodes, it also does not allow for the printing of gridlines narrower than ∼100 microns. In addition, screen printing methods can lead to solar cell breakage due to the fact that the cell must be mechanically handled. There is therefore a need for methods for printing front grid electrodes that afford gridlines that are 100 microns wide or less, while minimizing cell breakage. For example, decreasing the gridline electrode width from 100 microns to 50 microns would create an additional 2% of active area on a standard solar cell. Further, there is a need for methods for printing front grid electrodes that minimize the contact and line resistances.

### Summary

It has been surprisingly found that an efficient way to meet the aforementioned needs is to form photovoltaic cell conductive features from inks comprising inventive nano-sized metal particles having a surface coating, either of a polymeric material or a ceramic material, such as a metal oxide. Preferably, the surface coating is capable of etching the passivating layer, e.g., a silicon nitride layer such that the metal phases of adjacent particles may sinter together form a continuous electrode structure that is in direct electrical contact with the emitter layer (e.g., n-type semiconductor layer). Nano-sized metal particles having a surface coating will have higher reactivity than their micron-sized counterparts, leading to lower processing temperatures of the cell. Lower processing temperatures can minimize the diffusion of silver into the silicon emitter layer of the solar cell, thus minimizing shunting of the cell. Also, nano-sized metal particles having a surface coating will have a lower sintering temperature and have the potential to change the phase space for silver dissolution/reprecipitation to enable better delivery of the silver to the emitter interface. Further, nano-sized metal particles having a surface coating will have a higher reactivity and lower sintering temperature (high interparticle diffusion rates) compared to micron-sized particles, thus enabling the creation of denser electrode layers and the opportunity for more aerial contact at the emitter interface. Finally, because of their size, nano-sized metal particles having a surface coating are a better match for the surface roughness of the passivating layer and should enable increased aerial physical contact with the surface and hence improve etching.

Metal-containing nanoparticles are particles that contain a metal or a metal alloy and have an average particle size from 1 nanometer to less than 1000 nanometers. Such particles have a wide variety of potential uses, such as, in the production of electrical conductors for electronic devices where, for example, silver nanoparticles can be applied to a substrate, such as by ink jet printing, and then sintered at a temperature significantly below the melting point of bulk silver to produce the desired conductor.

In a first aspect, the present invention relates to a process for forming a photovoltaic conducive feature, as recited in claim 1.

Claim 18 recites an alternative process and claim 10 recited a photovoltaic conductive feature obtained by the process of claim 1. Further advantageous embodiments are recited in the dependent claims.

### Brief Description of the Drawings

FIG. 1 is a schematic diagram of a solar cell showing the electrical connection path.
FIG. 2 is a cross-sectional side view of a flame reactor for use in one aspect of the invention.
FIG. 3 is a cross-sectional side view of a flame reactor for use in another aspect of the invention.
FIG. 4 is a cross-sectional side view of a flame reactor for use in yet another aspect of the invention.
FIG. 5 provides a cross-sectional side view of a nozzle assembly for use in a flame reactor such as that shown in FIGS. 2 to 4.
FIG. 6 provides a front-end cross sectional view of the nozzle assembly in FIG. 5.
FIG. 7 provides a front perspective view of the nozzle assembly in FIG. 4.
FIGS. 8 (a) and (b) are transmission electron microscope (TEM) micrographs at different magnifications of Ag/SiO₂ particles produced according to Example 3 and using 30 %wt Ag loading in the precursor mixture.
FIGS. 9 (a) and (b) are TEM and scanning tunneling electron microscope (STEM) micrographs, respectively, of Ag/SiO₂ particles produced according to Example 5 and using 80 %wt Ag loading in the precursor mixture.
FIGS. 10 (a) and (b) are STEM and TEM micrographs, respectively, of Ag/SiO₂ particles produced according to Example 6 and using 90 %wt Ag loading in the precursor mixture.
FIGS. 11 (a) and (b) are STEM and TEM micrographs, respectively, of Ag/SiO₂ particles produced according to Example 7 and using 95 %wt Ag loading in the precursor mixture.
FIG. 12 is a TEM micrograph at higher magnification than that of FIG. 8 (a) of Ag/SiO₂ particles produced according to Example 5 and using 80 %wt Ag loading in the precursor mixture.
FIG. 13 is a TEM micrograph of Ag/SiO₂ particles produced according to Example 8 and using 98 %wt Ag loading in the precursor mixture.
FIG. 14 is a graph showing the particle size distribution as measured by QELS for the Ag/SiO₂ particles produced according to Example 8.
FIG. 15 (a) is a graph plotting SiO₂ coating thickness against Ag precursor content as a function of Ag particle size and FIG. 14(b) is a graph plotting SiO₂ coating thickness against silver precursor content for 20 nm Ag particles.
FIG. 16 is a graph plotting the x-ray diffraction (XRD) crystal size of the Ag in the final product against weight % silver content in the final product.
FIG. 17 is a graph plotting weight % silver content in the final product against the BET surface area of the final particulate product.
FIG. 18 is a graph plotting weight % silver content in the final product against the size of the silver aggregates in the final particulate product.
FIG. 19 is a graph plotting weight % silver content in the final product against the density of the final particulate product.
FIG. 20 is a graph plotting weight % silver content in the final product against the mean particle size of the final particulate product as determined by QELS.
FIGS. 21 (a) and (b) are TEM micrographs of Ag/SiO₂ particles produced according to Example 7 and using 95 %wt Ag loading in the precursor mixture.
FIG. 22 is a TEM micrograph of Ag/ZnO particles produced according to Example 10 and using 90 %wt Ag loading in the precursor mixture.
FIG. 23 is a TEM micrograph of Ag/SiO₂ particles produced according to Example 11 and using AgNO₃ as the silver source and 99 %wt Ag loading in the precursor mixture.
FIG. 24 is a TEM micrograph of glass frit particles containing Be₂O₃ 55 wt%; B₂O₃ 23 wt%; and ZnO 22 wt%.
FIG. 25 is a TEM micrograph of a silver-silica nanocomposite containing Ag 99 wt% and SiO₂ 1 wt%.
FIG. 26 is a SEM micrograph of a nanocomposite containing a silver core 99 wt% and a shell (Bi₂O₃ 55 wt%; B₂O₃ 23 wt%; and ZnO 22 wt%) 1 wt%.

### Detailed Description Of The Embodiments

The present invention, in one embodiment, relates to a process for forming a photovoltaic conductive feature, comprising:
(a) depositing a composition onto at least a portion of a substrate, wherein the composition comprises metal-containing particles having a primary particle size of from about 10 nanometers to less than 500 nanometers and including a continuous or non-continuous coating of a ceramic material; and (b) heating the composition such that the precursor composition forms at least a portion of a photovoltaic conductive feature. In some embodiments, the ceramic-coated, metal-containing nanoparticles are produced in a single step vapor phase process.

### Metal-containing particles

The particles used to produce the photovoltaic conductive features of the present invention have a core/shell configuration, in which the core is composed of a metal or metal alloy and shell is composed of a ceramic material. The particles may be present as individual metal-containing particles, each having a discrete continuous or non-continuous coating of the ceramic material and/or the particles may be present as aggregates of multiple metal-containing particles within a common matrix of the ceramic material. As will be discussed in more detail below, the nature of the metal-containing particles, as aggregates and/or as individual particles, will depend upon the relative amounts of metal and ceramic precursors in the input to the vapor phase synthesis process. In some embodiments, the metal-containing particles are crystalline metal-containing particles.

The metal in the particles may include virtually any type of metal and can include both single metals and metal alloys. Particularly preferred metals include at least one of palladium (Pd), silver (Ag), nickel (Ni), cobalt (Co), copper (Cu), gold (Au), platinum (Pt), molybdenum (Mo), tungsten (W), zinc (Zn), ruthenium (Ru), titanium (Ti), and the like. Typical alloys include a Ag/Pd alloy, such as one having a Ag:Pd ratio of about 70:30, as well as Cu/Ni, Cu/Zn, and Pd/Pt alloys. Preferred are metal-containing particles comprising at least one of palladium, silver, nickel, copper, gold and platinum, and even more particularly those including at least one of palladium, silver, nickel and copper. Most preferably, the metal is silver or a silver alloy.

Similarly, the choice of ceramic material is not narrowly limited, although in the usual case, where the ceramic material condenses at a higher temperature than the metal in the vapor phase synthesis process, the relative surface wetting properties of the metal and the ceramic should be such as to allow redistribution of the metal, as it condenses on the ceramic, to form a surface layer to the core of the final particle. Typically the ceramic shell material includes an oxide, such as an oxide of at least one of silicon, zirconium, titanium, aluminum, cerium, zinc, tin, bismuth, molybdenum, manganese, vanadium, niobium, tantalum, tungsten, iron, chromium, cobalt, nickel, copper, yttrium, bismuth, magnesium, thorium, ruthenium and gadolinium. In some embodiments, the ceramic material comprises a mixture of a plurality of metal oxides. In other embodiments, the ceramic shell material comprises two or more oxides of silicon, zirconium, titanium, aluminum, cerium, zinc, tin, bismuth, molybdenum, manganese, vanadium, niobium, tantalum, tungsten, iron, chromium, cobalt, nickel, copper, yttrium, bismuth, magnesium, thorium, ruthenium and gadolinium. In some embodiments, the ceramic shell material comprises an oxide of at least one element selected from lead, strontium, sodium, calcium, bismuth, and boron. In some embodiments, the ceramic shell material comprises an oxide of two or more oxides of at least one element selected from lead, strontium, sodium, calcium, bismuth, and boron. Some preferred oxides are silica, titania, zirconia, ceria, and tin oxide, with silica being particularly preferred. In all cases, these oxides can be doped with low or high amounts of dopant elements, where high doping concentration can result in formation of distinct mixed metal oxide phases. In some cases, the oxide or oxides used as the ceramic material can produce a glass-like shell on the particles. The oxide can be a complex oxide consisting of two or more elements, e.g. Y-Yb-O, Ba-Ti-O, Zn-Si-B-O and others. Furthermore, a variety of other ceramic materials may be used to produce the particle shell, such as carbides, for example silicon or titanium carbides; borides, for example titanium boride; and nitrides, including silicon or titanium nitrides; silicides, for example titanium silicide; oxynitrides; oxysulfides; and oxycarbides.

Depending on the specific materials chosen for the metal core and ceramic shell, the final particles may exhibit enhanced or additional functionality as compared with nanoparticles of the uncoated metal. For example, the oxide layer can be a partially transparent color layer, in which case the final metal/metal oxide particle may exhibit metallic reflectivity combined with color. In addition, if SiO₂ is employed as the shell material, various known methods for treating silica surfaces (such as silanation, imparting of hydrophobic or hydrophilic properties, addition of different ligands to the silica surface, modification of surface acidity, and others) can be employed to provide the particles with functionalities such as enhanced adhesion, improved wear and environmental resistance, and reduced curing time. In some embodiments particles are functionalized with a one or more functional groups. In some embodiments, the functional groups comprise a silane, e.g., a silane comprising hexamethyl disilazane. In other embodiments, the functional groups comprise a siloxane, e.g., an ethylene oxide functional siloxane such as Gelest 2-methoxy(polyethyleneoxy) propyltrimethoxysilane.

The particles (as individual particles or as part of an aggregate) of some embodiments of the present invention have small crystal domains having a size of less than 50 nm as measured by X-ray diffraction (XRD) and having a primary particle size as measured by transmission electron microscopy (TEM) of from about 10 nanometers to less than 100 nanometers, typically from about 10 nanometers to about 80 nanometers, such as from about 10 nanometers to about 50 nanometers, or from about 20 nanometers to about 60 nanometers, for example from about 30 nanometers to about 50 nanometers.

In some embodiments the particles have a primary particle size of from about 10 nanometers to about 500 nanometers, such as from about 10 nanometers to about 300 nm, from about 10 nanometers to about 200 nm, and from about 10 nanometers to about 100 nm.

In addition, in some embodiments, whether present as aggregates or individual coated particles the metal or metal alloy domains tend to exhibit a narrow particle size distribution such that at least 80 weight percent, preferably at least 90 weight percent of the particles, have a size of less than 500 nanometers, wherein the particle size distribution is measured using quasi-electric light scattering (QELS). In some embodiments, the metal-containing particles have a particle size distribution such that at least 90 weight percent of the particles have a size of less than 2 µm, e.g., less than 1 µm. Additionally, in an optional embodiment, the metal-containing particles include a small amount of micron-sized particles. For example, the particles optionally have a particle size distribution such that at least 1 weight percent, e.g., at least 5 weight percent or at least 10 weight percent of the particles have a size of greater than 1 µm.

In some embodiments, when the metal-containing particles are present in the powder batch as aggregates, the aggregates generally have a weight average particle size of less than 500 nanometers, such as less than 300 nanometers, for example less than 200 nanometers, in some cases less than 100 nanometers, and less than 50 nanometers, wherein the aggregate size is measured using quasi-electric light scattering (QELS). In some embodiments, the aggregates have a particle size of from 75 nanometers to 500 nanometers, e.g., from 75 nanometers to 300 nanometers, from 75 nanometers to about 200 nanometers, or from 100 nanometers to 500 nanometers. Typically, each the aggregates comprises an average of less than 20, for example an average of less than 10, such as an average of less than 5, of said metal-containing particles per aggregate.

Because of their small size, the aggregates preferably are ink-jettable without comminution. Typically, the aggregates comprise an average of less than 20, for example an average of less than 10, such as an average of less than 5, of said metal-containing particles per aggregate.

In some embodiments, whether the particles are individual coated metal-containing particles and/or aggregates of multiple metal-containing particles within a common matrix of the ceramic material, the volume ratio of metal to ceramic material in each particle is normally at least 9:1 (90 vol% metal/10 vol% ceramic), such as at least 19:1 (95 vol% metal/5 vol% ceramic), and at least 98:1 (98 vol% metal/1 vol% ceramic). As a result, the thickness of the ceramic coating is generally very thin (typically less than 10 nanometers) so that, in the case of the preferred embodiment of a silica-coated silver particles, although the coating serves to prevent agglomeration of the particles, thin films produced from the particles are reflective and at high silver concentration (>95 %wt) the particles are conductive.

### Vapor Phase Synthesis

The particles employed in the processes of the present invention may be produced by a single step process in which precursors to the metal/alloy core and ceramic coating of the nanoparticles are vaporized in a high temperature reaction zone to form a vapor of the ceramic and a the vapor of metal/alloy, whereafter the vapors are allowed to condense/nucleate to form the desired nanoparticles. Normally, the ceramic material has a higher boiling point than the metal/alloy and so is assumed to condense from the vapor before the metal component. While not being bound by any particular theory, it is believed that the metal/alloy vapor then condenses as metal/alloy nanoclusters on the already-formed ceramic particles. However, at the high temperatures involved, it is believed that the metal/alloy is highly mobile and the particles rearrange to the thermodynamically preferred form in which the lower surface energy ceramic component is present as an external coating on metal-containing nanoparticles.

By the term "precursor" is meant a composition that includes at least one component for inclusion in the nanoparticulates. By "component" is meant at least some identifiable portion of the precursor that becomes a part of the nanoparticulates. For example, the component could be the entire composition of the precursor when that entire composition is included in the nanoparticulates. For example, in one embodiment, the ceramic material itself is vaporized and contacted with the vapor of the metal/alloy precursor. More often, however, the component will be something less than the entire composition of the precursor, and may be only a constituent element present in both the composition of the precursor and the nanoparticulates. For example, it is often the case that in the high temperature reaction zone the precursor decomposes, and one or more than one element in a decomposition product then becomes part of the nanoparticulates, for example the metal/alloy core or metal oxide coating, either with or without further reaction of the decomposition product.

The precursors can be any materials that will vaporize or has intermediate products that can vaporize and, if necessary, decompose to produce the desired ceramic and metal/alloy vapors in the high temperature reaction zone. In the case of the metal/alloy component, the precursor will generally be one or more metal salts that can be dissolved in the liquid vehicle. Such salts can include simple inorganic acid salts, such as nitrates and chlorides. However, in the preferred embodiment where the high temperature reaction zone is part of a flame reactor, it may be desirable to employ one or more precursors in the form of salts of organic acids, such as metal carboxylates, metal alkoxides, or other organic derivatives so that the precursors provide at least part of the fuel for the flame reactor. Similarly, organic derivatives can be employed as precursors of the ceramic shell so that, for example, where the ceramic shell is silica, a suitable precursor includes hexamethyldisiloxane.

In conducting the present synthesis process, it is found that the volume ratio of the metal precursor to the ceramic precursor is important in producing the desired nanoparticles comprising a metal core surrounded by a ceramic shell. The precise ratio is dependent on the particular metal and ceramic employed but, in general, it is found that the volume ratio of metal to ceramic in the precursor mixture should be at least 4:1, such as at least 9:1, for example at least 19:1, at least 47:1 or at least 98:1.

Generally, the precursors are introduced into the high temperature reaction zone in a nongaseous state. Rather, as introduced into the reactor, the precursor will be, or be part of, one or more of a liquid, a solid or a supercritical fluid feed to the reactor. In one convenient implementation, the precursor is contained within a nongaseous dispersed phase material, such as in droplets of liquid sprayed into the internal reactor volume

In one preferred embodiment, vaporization of the metal/alloy precursor and the ceramic precursor is achieved by dispersing the precursors in one or more liquid vehicles, atomizing the liquid vehicle(s) to produce an aerosol containing the precursors and then introducing the aerosol into a high temperature reaction zone, such as that generated by a plasma reactor or more preferably by a flame spray or laser reactor. Generally, the high temperature reaction zone is at a temperature of at least 1000°C, such as at least 1500°C, for example at least 2000°C. Generally, higher temperatures in the reaction zone favor the formation of larger nanoparticles.

The precursor to the metal/alloy core can be dispersed in the same liquid vehicle as the precursor to the ceramic shell or the precursors can be dispersed in different liquid vehicles. Moreover, each precursor can be dispersed in its liquid vehicle by partly or wholly dissolving the precursor in the vehicle or instead the precursor can be dispersed in its liquid vehicle as a slurry or emulsion of solid precursor particles so that, after atomization, the aerosol produced comprises droplets containing precursor particles.

The liquid vehicle can be organic, aqueous, or an organic/aqueous mixture. Some nonlimiting examples of organic liquid vehicles include alcohols (e.g., methanol, ethanol, isopropanol, butanol), organic acids, glycols, aldehydes, ketones, ethers, waxes, or fuel oils (e.g., kerosene or diesel oil), toluene and gasoline. In addition to or instead of the organic liquid, the liquid vehicle may include an inorganic liquid, which will typically be aqueous-based. Some non-limiting examples of such inorganic liquids include water and aqueous solutions, which may be pH neutral, acidic or basic. The liquid vehicle may include a mixture of mutually soluble liquid components, such as a mixture of mutually soluble organic liquids or a mixture of water with one or more organic liquids that are mutually soluble with water (e.g., some alcohols, ethers, ketones, aldehydes, etc.). Alternatively, liquid vehicle may contain multiple distinct liquid phases, for example, an emulsion, such as an oil-in-water or a water-in-oil emulsion.

In addition to acting as a carrier for the precursor(s), the vehicle may have a variety of other functions. For example, when the high temperature reaction zone is part of a flame spray reactor, the liquid vehicle may be or include a component that is a fuel or an oxidant for combustion in a flame of the flame reactor. Such fuel or oxidant in the liquid may be the primary or a supplemental fuel or oxidant for driving the combustion in a flame.

When the precursors are introduced into the high temperature reaction zone as an aerosol in a liquid vehicle, in one preferred embodiment the aerosol droplets are dispersed in a gas phase. The gas phase may include any combination of gas components in any concentrations. The gas phase may include only components that are inert (i.e. nonreactive) in the reactor or the gas phase may comprise one or more reactive components (i.e., decompose or otherwise react in the reactor). When the high temperature reaction zone is generated in a flame reactor, the gas phase may comprise a gaseous fuel and/or oxidant for combustion in the flame. Non-limiting examples of suitable gaseous oxidants are gaseous oxygen (which could be provided by making the gas phase from or including air) and carbon monoxide. Non-limiting examples of gaseous fuels that could be included in the gas phase include hydrogen gas and gaseous organics, such as hydrocarbons (e.g., methane, ethane, propane, butane). Often, the gas phase will include at least oxidant (normally oxygen in air) and fuel delivered separately to the flame. Alternatively, the gas phase may include both fuel and oxidant premixed for combustion in a flame. Also, the gas phase may include a gas mixture containing more than one oxidant and/or more than one fuel. Also, the gas phase may include one or more than one gaseous precursor for a material of the nanoparticulates. For example, when the ceramic shell includes an oxide material, the gaseous precursor can be an oxygen-containing gas, such as air.

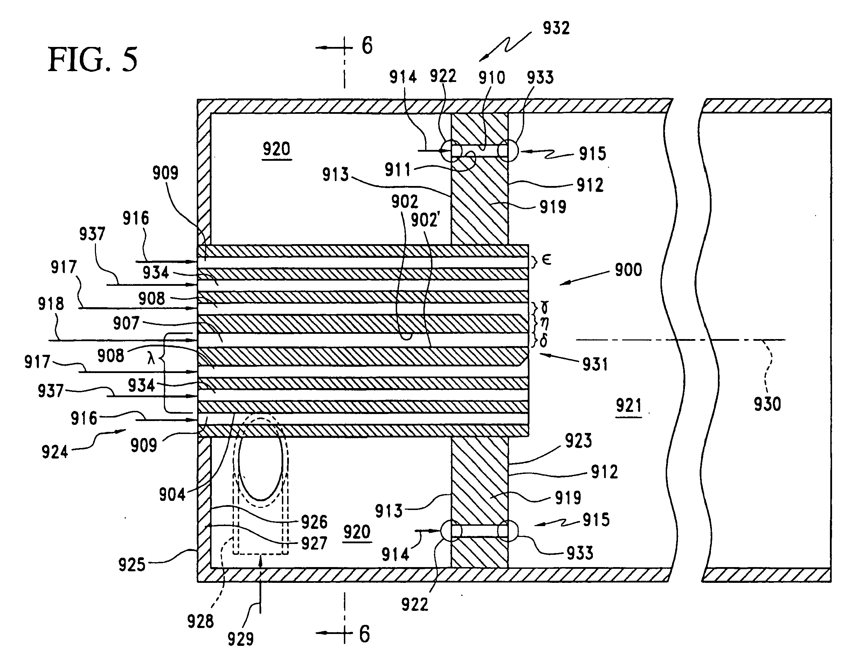

Where the precursors are introduced into the high temperature reaction zone as an aerosol in a liquid vehicle, the aerosol can be produced using any suitable device that disperses liquid into droplets, such as for example, a spray nozzle. Examples of suitable spray nozzles include ultrasonic spray nozzles, multi-fluid spray nozzles and pressurized spray nozzles. One example of a suitable multi-fluid spray nozzle is shown in FIGS. 5 to 6 discussed in detail below.

Ultrasonic spray nozzles generate droplets of liquid by using piezoelectric materials that vibrate at ultrasonic frequencies to break up a liquid into small droplets. Pressurized nozzles use pressure and a separator or screen in order to break up the liquid into droplets. In some cases, pressurized nozzles may involve use of some vapor that is generated from the liquid itself in order to pressurize and break up the liquid into droplets. One advantage of using ultrasonic and pressurized nozzles is that an additional fluid is not required to generate liquid droplets. This may be useful in situations where the precursor dissolved in the liquid vehicle is sensitive and/or incompatible with other common fluids used in multi-fluid spray nozzles.

In addition to the use of a spray nozzle for dispersing the liquid medium, any other suitable device or apparatus for generating disperse droplets of liquid may be used in the generating step. One example of a device that is useful in generating droplets of liquid is an ultrasonic generator. An ultrasonic generator uses transducers to vibrate liquids at very high frequencies which break up the liquid into droplets. One example of an ultrasonic generator that is useful with the present invention is disclosed in U.S. Patent No. 6,338,809, incorporated herein by reference in its entirety. Another example of a device that is useful in generating droplets of liquid is a high energy atomizer such as those used in carbon black production.

In one preferred embodiment, the coated nanoparticles are produced using a flame reactor. By a "flame reactor" is meant a reactor having an internal reactor volume directly heated by one or more than one flame when the reactor is operated. By "directly heated" is meant that the hot discharge of a flame flows into the internal reactor volume. By the term "flame" is meant a luminous combustion zone.

Each flame of the flame reactor will typically be generated by a burner, through which oxidant and fuel are fed to the flame for combustion. The burner may be of any suitable design for use in generating a flame, although the geometry and other properties of the flame will be influenced by the burner design. Some exemplary burner designs that may be used to generate a flame for the flame reactor are discussed in detail in U.S. Patent Application No. 11/335,727 filed January 20, 2006 (Attorney Docket No. 2005A004.2), the entirety of which is incorporated herein by reference. Each flame of the flame reactor may be oriented in any desired way. Some non-limiting examples of orientations for the flame include horizontally extending, vertically extending or extending at some intermediate angle between vertical and horizontal. When the flame reactor has a plurality of flames, some or all of the flames may have the same or different orientations.

Each flame of the flame reactor will often be associated with an ignition source that ignites the oxidant and fuel to generate the flame. In some instances, the ignition source will be one or more pilot flames that in addition to providing an initial ignition source to start the combustion of the oxidant and the fuel, may also provide a continual ignition/energy source that sustains the flame of the flame reactor. The pilot flame may be generated from the same oxidant and fuel used to generate the main flame, or from a different fuel and/or oxidant. For example, when using the same fuel, a pilot flame may be generated using a small stream of fuel flowing through one channel of a multi-channel burner used to generate a flame of the flame reactor. The small stream of fuel may be premixed with an oxidant or may consume oxygen from the ambient environment to generate the pilot flame. The ignition source is not limited to pilot flames and, in some cases, the ignition source may be a spark or other ignition source.

Also, each flame has a variety of properties (e.g., flame geometry, temperature profile, flame uniformity, flame stability), which are influenced by factors such as the burner design, properties of feeds to the burner, and the geometry of the enclosure in which the flame is situated.

One important aspect of a flame is its geometry, or the shape of the flame. Some geometries tend to provide more uniform flame characteristics, which promotes manufacture of the nanoparticulates with relatively uniform properties. One geometric parameter of the flame is its cross-sectional shape at the base of the flame perpendicular to the direction of flow through the flame. This cross-sectional shape is largely influenced by the burner design, although the shape may also be influenced by other factors, such as the geometry of the enclosure and fluid flows in and around the flame. Other geometric parameters include the length and width characteristics of the flame. In this context the flame length refers to the longest dimension of the flame longitudinally in the direction of flow and flame width refers to the longest dimension across the flame perpendicular to the direction of flow. With respect to flame length and width, a wider, larger area flame, has potential for more uniform temperatures across the flame, because edge effects at the perimeter of the flame are reduced relative to the total area of the flame.

In addition to the shape of the flame(s), which may help control temperature profiles, it is also possible to control the feeds introduced into the flame. One example of an important control parameter is the ratio of fuel (e.g., liquid vehicle) to oxidant that is fed to the flame. In some embodiments, a precursor introduced into a flame may be easily oxidized, and it may be desirable to maintain the fuel to oxidant ratio at a fuel rich ratio to ensure that no excess oxygen is introduced into the flame. The fuel rich environment ensures that all of the oxygen that is introduced into the flame will be combusted and there will be no excess oxygen available in the flame reactor to oxidize the nanoparticles or precursors. In other words, there is a stoichiometric amount of oxygen in the feed that promotes the complete combustion of all the fuel present, thereby leaving no excess oxygen. In other embodiments, it may be desirable to have a fuel to oxidant ratio that is rich in oxygen. For example, when making metal oxide ceramics, it may be desirable to maintain the environment within a flame and in the flame reactor with excess oxygen.

In addition to the environment within the flame and the flame reactor, the fuel to oxidant ratio controls other aspects of the flame, such as flame temperature. If the fuel to oxidant ratio is at a fuel rich ratio then the flame reactor will contain fuel that is uncombusted. Unreacted fuel generates a flame that is at a lower temperature than if all of the fuel that is provided to the flame reactor is combusted. Uncombusted fuel can also introduce carbon contamination in the product particles. Thus, in those situations in which it is desirable to have all of the fuel combusted in order to maintain the temperature of a flame at a high temperature, it will be desirable to provide to the flame reactor excess oxidant to ensure that all of the fuel provided to the flame or flame reactor is combusted. However, if it is desirable to maintain the temperature of the flame at a lower temperature, then the fuel to oxidant ratio may be fuel rich so that only an amount of fuel is combusted so that the flame does not exceed a desired temperature.

The total amount of fuel and oxidant fed into the flame determines the velocity of the combusted gases, which, in turn, controls the residence time of the primary particles formed in the flame. The residence time in the flame of the primary particles determine the product particle size and in some cases the morphology of the product particles. The relative ratio of oxygen to fuel also determines the concentration of particles in the flame which, in turn, determines the final product particle size and morphology. More dilute flames will make smaller or less aggregated particles.

The specific type of fuel will also affect the temperature of the flame. In addition to the temperature of the flame, the selection of a fuel may involve other considerations. Fuels that are used to combust and create the flame may be gaseous or nongaseous. The nongaseous fuels may be a liquid, solid or a combination of the two. In some cases, the fuel combusted to form the flame may also function as a solvent for a precursor. The advantage of this is that the precursor is surrounded by fuel in each droplet which upon combustion provides optimum conditions for precursor conversion. In other embodiments, the liquid fuel may be useful as a solvent for the precursor but not contain enough energy to generate the required heat within the flame reactor for all of the necessary reactions. In this case, the liquid fuel may be supplemented with another liquid fuel and/or a gaseous fuel, which are combusted to contribute additional heat to the flame reactor. Nonlimiting examples of gaseous fuels that may be used with the method of the present invention include methane, propane, butane, hydrogen and acetylene. Some nonlimiting examples of liquid fuels that may be used with the method of the present invention include alcohols, toluene, acetone, isooctane, acids and heavier hydrocarbons such as kerosene and diesel oil.

One criterion that may be employed for the selection of gaseous and nongaseous fuels is the enthalpy of combustion of the fuel. The enthalpy of combustion of a fuel determines the temperature of the flame, the associated flame speed (which affects flame stability) and the ability of the fuel to bum cleanly without forming carbon particles. In general higher enthalpy fuels produce higher temperature flames that favor the formation of larger nanoparticles.

In some cases the fuel will be a combination of liquids, which can be desirable to dissolve when the precursors are soluble in liquids that are low energy fuels. In this case, the low energy fuel (e.g., the liquid vehicle) may be used to dissolve the precursors, while an additional higher energy fuel may supplement the low energy fuel to generate the necessary heat within the flame reactor. In some instances, the two liquid fuels may not be completely soluble in one another, in which case the liquid will be a multiphase liquid with two phases (i.e., an emulsion). Alternatively, the two liquid fuels may be introduced separately into the flame from separate conduits (e.g., in a multi-fluid nozzle case). In other instances the two liquids may be mutually soluble in each other and form a single phase. It should be noted that in other cases there may be more than two liquid fuels introduced into the flame, the liquids may be completely soluble in one another or may be in the form of an emulsion.

The oxidant used to combust the fuel to form the flame may be a gaseous oxidant or a nongaseous oxidant. The nongaseous oxidant may be a liquid, a solid or a combination of the two. However, preferably the oxidant is a gaseous oxidant and will optionally comprise oxygen. The oxygen may be introduced into the flame reactor substantially free of other gases such as a stream of substantially pure oxygen gas. In other cases, the oxygen will be introduced into the flame reactor with a mixture of other gases such as nitrogen, as is the case when using air. Although it is preferable to have a gaseous oxidant, in some cases the oxidant may be a liquid. Some examples of liquids that may be used as oxidants include inorganic acids. Also, the oxidant that is introduced into the flame reactor may be a combination of a gaseous oxidant or a liquid oxidant. This may be the case when it is desirable to have the nongaseous precursor dissolved in a liquid to disperse it, and it also desirable to have the oxidant located very close to the nongaseous precursor when in the flame reactor. In this case, the precursor may be dissolved in a liquid solvent that functions as an oxidant.

Discharge from each flame of the flame reactor flows through a flow path, or the interior pathway of a conduit, through the flame reactor. As used herein, "conduit" refers to a confined passage for conveyance of fluid through the flame reactor. When the flame reactor comprises multiple flames, discharge from any given flame may flow into a separate conduit for that flame or a common conduit for discharge from more than one of the flames. Ultimately, however, streams flowing from each of the flames generally combine in a single conduit prior to discharge from the flame reactor.

A conduit through the flame reactor may have a variety of cross-sectional shapes and areas available for fluid flow, with some nonlimiting examples including circular, elliptical, square or rectangular. In most instances, however, conduits having circular cross-section are preferred, since the presence of sharp corners or angles may create unwanted currents or flow disturbances that can promote deposition on conduit surfaces. Walls of the conduit may be made of any material suitable to withstand the temperature and pressure conditions within the flame reactor. The nature of the fluids flowing through the flame reactor may also affect the choice of materials of construction used at any location within the flame reactor. Temperature is, however, generally the most important variable affecting the choice of conduit wall material. For example, quartz may be a suitable material for temperatures up to about 1200°C, whereas, for temperatures up to about 1500°C, possible materials for the conduit include alumina, mullite and silicon carbide. As yet another example, for processing temperatures up to about 1700°C, graphite or graphitized ceramic might be used for conduit material.

The precursors are introduced into the flame reactor in a very hot zone, also referred to herein as a primary zone, that is sufficiently hot that substantially all of materials flowing through that portion of the primary zone are in the vapor phase. The precursors may enter the vapor phase by any mechanism. For example, the precursors may simply vaporize, or one or more precursors may decompose to produce a component of the final nanoparticles, which component enters the gas phase as part of a decomposition product. Eventually, however, the component leaves the gas phase as particle nucleation and growth occurs. Removal of the component from the gas phase may involve simple condensation as the temperature decreases or may include additional reactions. For example, remaining vaporized precursor may react on the surface of the already nucleated monomers by any surface reaction mechanism.

The growing step commences with particle nucleation and continues due to collision and agglomeration and sintering of smaller particles into larger particles or through addition of additional material into the flame reactor for addition to the growing nanoparticles. The growth of the nanoparticles may involve added material of the same type as that already present in the nanoparticles or addition of a different material, such as a flux to promote fusing, sintering and/or coalescing of the nanoparticles. Depending on the temperature and the residence time in the primary zone of the reactor, the particles may completely fuse upon coagulation to form individual spheres or they can partially fuse to form hard fractal-like aggregates. In general, increasing the temperature and the residence time in the flame reactor increases the particle size of the nanoparticles. Similarly, increasing the concentration of the precursors in the liquid vehicle tens to result in increased size of the nanoparticles.

When making extremely small particles, the growing step may mostly or entirely occur within the primary zone of the flame reactor immediately after the flame. However, when larger particle sizes are desired, processing may be required in addition to that occurring in the primary zone of the flame reactor. As used herein, "growing" the nanoparticles refers to increasing the weight average particle size of the nanoparticles. At least a portion of the growing step will optionally be performed in a volume of the flame reactor downstream from the primary zone that is better suited for controllably growing nanoparticles to within the desired weight average particle size range. This downstream portion of the flame reactor is referred to herein as a secondary zone to conveniently distinguish it from the primary zone discussed above. In most instances, the primary zone will be the hottest portion within the flame reactor.

The residence time of the stream of growing nanoparticles in the secondary zone may be longer than the residence time in the primary, or hot zone. By the term "residence time" it is meant the length of time that the flowing stream, remains within a particular zone (e.g., primary zone or secondary zone) based on the average stream velocity through the zone and the geometry of the zone. For example, the flowing stream typically has a residence time in the primary zone (and also the flame) in a range having a lower limit selected from the group consisting of 1 ms, 10 ms, 100 ms, and 250 ms and an upper limit selected from the group consisting of 500 ms, 400 ms, 300 ms, 200 ms and 100 ms. In one embodiment, the residence time of the flowing stream in the secondary zone is at least twice as long, four times as long, six times or ten times as long as the residence time in the primary zone. Thus the residence time of the flowing stream in the secondary zone is often in a range having a lower limit selected from the group consisting of 50 ms, 100 ms, 500 ms, 1 second and 2 seconds and an upper limit selected from the group consisting of 1 second, 2 seconds, 3 seconds, 5 seconds and 10 seconds. In one embodiment, the total residence time for both the primary zone and the secondary zone is in a range having a lower limit selected from the group consisting of 100 ms, 200 ms, 300 ms, 500 ms and 1 second and an upper limit selected from the group consisting of 1 second, 2 seconds, 3 seconds, 5 seconds and 10 seconds.

In determining an appropriate residence time of the nanoparticles in the secondary zone there are several factors to be considered including the desired weight average particle size, the melting temperature (and sintering temperature) of materials in the nanoparticles, the temperature within the secondary zone, and the number concentration of the nanoparticulates in the flowing stream (i.e., number of nanoparticles per unit volume of the flowing stream).

With respect to the number concentration of nanoparticles flowing through the secondary zone, if such number concentration is sufficiently large, then the nanoparticles will tend to collide more frequently providing greater opportunity for particle growth more quickly, requiring less residence time within the secondary zone to achieve a desired weight average particle size. Conversely, if the nanoparticulate concentration within the secondary zone is small, the collisions between nanoparticles will be less frequent and particle growth will necessarily proceed more slowly. Moreover, there is a particular number concentration of nanoparticles, referred to herein as a "characteristic number concentration," below which particle collisions become so infrequent that for practical purposes the nanoparticles effectively stop growing due to particle collisions. The characteristic number concentration will be different for different weight average particle sizes.

If the temperature within the secondary zone is set to promote the growth of the nanoparticles through collisions of the nanoparticles (i.e. high enough for colliding particles to fuse to form a single nanoparticulate), then control of the number concentration of the nanoparticles and residence time in the secondary zone are two important control variables. Thus, if the number concentration of nanoparticles in the secondary zone is maintained at a specific concentration, then the residence time within the secondary zone can be changed in order to achieve the desired extent of collisions to achieve a weight average particle size in a desired range. However, if the residence time is set, then the number concentration of nanoparticles within the secondary zone may be controlled so that the desired weight average particle size is achieved within the set residence time. Control of the weight average particle size may be achieved for example by changing the temperature in the secondary zone and changing the concentration of the precursor in feed to the primary zone, or a combination of the two, or by changing the reactor cross-sectional area and/or the cross-sectional area of the flame at its broadest point. In one embodiment, the ratio of the cross-sectional area of the flame at its broadest point to the cross-sectional area of the reactor at that same point is preferably 0.01 to 0.25. Conversely, for a set residence time and temperature profile in the secondary zone, the concentration of nongaseous precursors (and other precursors) fed to the primary zone may be adjusted to achieve a desired volume concentration in the secondary zone to achieve at least the characteristic volume concentration for a desired weight average particle size.

Temperature control in the secondary zone of the flame reactor is very important. Maintaining the temperature of the secondary zone within a specific elevated temperature range may include retaining heat already present in the flowing stream (e.g., residual heat from the flame in the primary zone). This may be accomplished, for example, by insulating all or a portion of the conduit through the secondary zone to reduce heat losses and retain a higher temperature through the secondary zone. In addition to or instead of insulating the secondary zone, heat may be added to the secondary zone to maintain the desired temperature profile in the secondary zone.

The temperature in the secondary zone is maintained below a temperature at which materials of the nanoparticles would vaporize or thermally decompose, but above a sintering temperature of the metal and/or ceramic component of the nanoparticles. By "sintering temperature" it is meant a minimum temperature, at which colliding nanoparticles sticking together will fuse to form a new primary particle within the residence time of the secondary zone. The sintering temperature of the nanoparticles will, therefore, depend upon the materials in the nanoparticles and the residence time of the nanoparticles in the secondary zone as well as the size of the nanoparticles. In those embodiments where the growing of the nanoparticles includes significant growth through particle collisions, the nanoparticles should be maintained at, and preferably above, the sintering temperature in the secondary zone.

In some cases, it may be preferable to contact the flowing stream containing the nanoparticles with a quench medium to reduce the temperature of the flowing stream before it enters the secondary zone. The quench medium is at a lower temperature than the flowing stream, and when mixed with the flowing stream it reduces the temperature of the flowing stream, and consequently also the nanoparticles in the flowing stream. The quenching step may reduce the temperature of the nanoparticles by any desired amount. For example, the temperature of the flowing stream may be reduced at a rate of from about 500°C/s to about 40,000°C/s. In some applications, the temperature of the flowing stream may be reduced at a rate of about 30,000°C/s, or about 20,000°C/s, or about 10,-000°C/s, or about 5,000°C/s or about 1,000°C/s.

The quench medium preferably comprises a quench gas. The quench gas may be non-reactive after introduction in the flame reactor and be introduced solely for the purpose of reducing the temperature of the flowing stream. This might be the case for example, when it is desired to stop the growth of the nanoparticles through further collisions. The quenching step helps to stop further growth by diluting the flowing stream, thereby decreasing the frequency of particle collisions, and reducing the temperature, thereby reducing the likelihood that colliding particles will fuse together to form a new primary particle. When it is desired to stop further particle growth, the cooled stream exiting the quenching step should preferably be below the sintering temperature of the nanoparticulates. The cooled nanoparticles may then be collected i.e., separated from the gas phase of the flowing stream.

The quenching step may also be useful in retaining a particular property of the nanoparticles as they have formed and nucleated in the flowing stream. For example, if the nanoparticles have nucleated and formed with a particular phase that is desirable for use in a final application, the quenching step may help to retain the desirable phase that would otherwise recrystallize or transform to a different crystalline phase if not quenched. In other words, the quenching step may be useful to stop recrystallization of the nanoparticles if it is desirable to retain a particular crystal structure that the nanoparticles have nucleated and formed with. Alternatively, the quench gas may be non-reactive, but is not intended to stop nanoparticulate growth, but instead to only reduce the temperature to accommodate some further processing to occur at a lower temperature.

As another alternative, the quench gas may be reactive in that it includes one or more components that is or becomes reactive in the flame reactor, such as reactive with material of the nanoparticles or with some component in the gas phase of the flowing stream in the flame reactor. As one example, the quench gas may contain a precursor for additional material to be added to the nanoparticles. The precursor may undergo reaction in the quench zone prior to contributing a material to the nanoparticulate, or may not undergo any reactions. In one specific example, the quench gas may contain oxygen, which reacts with a metal in the nanoparticles to promote production of a metal oxide in the nanoparticles or it may react with carbon contained in the-nanoparticles to convert it to CO₂. The quenching may also help in production of metastable phases by kinetically controlling and producing a phase that is not preferred thermodynamically.

The quench medium is normally introduced into the flame reactor in a quench zone immediately downstream of the primary zone. However, the quench medium can also be introduced into the primary zone by, for example, introducing the quenching medium through the burner and around the precursor jet by properly designing the spray nozzle. This provides a cooling "envelope" that surrounds the main jet flame. Alternatively, the quenching medium can be introduced into the center of the burner and may be surrounded by the flame. This allows quenching of the flame from its core. Finally, a combination of the above two approaches can be used to cool the flame internally and externally.

In other embodiments, it may be desirable to provide a sheathing medium that at least partly surrounds the flame produced by the flame spray reactor to effect at least one of (a) cooling the flame; (b) facilitating the flow of the product nanoparticles through the flame spray system; (c) cooling any metal surfaces located around the flame; (d) preventing the formation of areas of turbulence within the internal reactor volume surrounding the burner and/or the flame; and (e) allowing the introduction of additional materials, *e.g*., oxidant or additional precursor medium, to the flame and/or the internal reactor volume. Typically, the sheathing medium comprises a gas, such as oxygen, nitrogen, air, off gas recycle, or water vapor. In another embodiment, the sheathing medium further comprises atomized water. If the sheathing medium comprises atomized water, the sheath medium optionally comprises the atomized water in an amount ranging from about 10 to about 100 percent by volume, e.g., from about 50 to about 100 percent or from about 90 to about 100 percent, based on the total volume sheathing medium.

The size and agglomeration of the metal particles can be controlled by controlling the size of the ceramic particles that are initially formed in the flame. Due to the high vapor pressure of the metal and much lower vapor pressure of the ceramic, it is postulated that the ceramic vapor that forms in the flame precipitates to form the solid particle of the ceramic while the metal is still in the vapor form. The ceramic particles will grow through collision and agglomeration to form primary or aggregate particles with morphology and size determined by the parameters mentioned above. At some point in space and time, metal vapor will start nucleating on the surface of the already present ceramic particles, which results in formation of metal particles within or on the surface of ceramic particle/aggregate. Due to high mobility of the metal at high temperature, inter-diffusion of metal/ ceramic, and metal/ ceramic wetting properties, the metal rearranges itself in such a way that the metal moves to the core and metal oxide moves to the outside of the new composite particle, forming coated particle. The size of the metal particle encapsulated in the ceramic depends on the size of the original ceramic particle/aggregate and the concentration of the metal in the reactor. While the inter-diffusion of metal within the original ceramic particle is vigorous at high temperature, the diffusion of metal between separate ceramic particles/agglomerates is very limited (or non-existent) due to the presence of ceramic on the outside of the aggregate. Each ceramic particle/aggregate is a separate domain in space within which metal can diffuse to form spherical metal particles. At the same time, the ceramic particles/domains serve as a barrier for diffusion of metal between different aggregates which would otherwise result in the formation of much larger metal particles.

Desirably, the flame spray process of the present invention occurs in an enclosed flame spray system, by which is meant that the flame spray system separates the flame from its surroundings and enables controlled input of, e.g., fuel/oxidant, precursors and liquid vehicle, such that the process can be metered and precisely controlled.

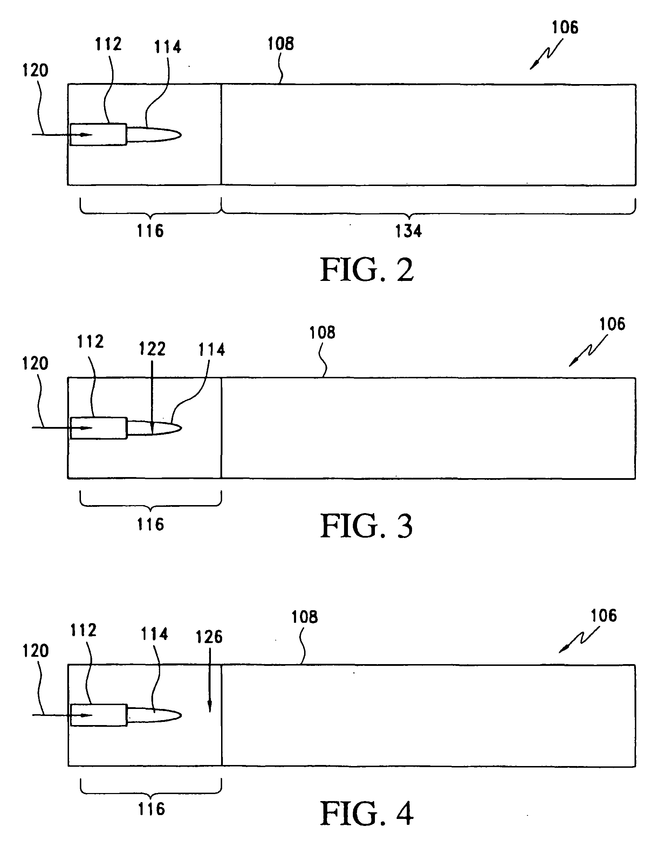

Referring to the drawings, one embodiment of an enclosed flame spray system is shown in FIG. 2 and includes a flame reactor 106, which comprises a tubular conduit 108 of a circular cross-section, a burner 112, and a flame 114 generated by the burner 112 and disposed within the tubular conduit 108. Flame reactor 106 has a very hot primary zone 116 that includes the flame 114 and the internal reactor volume in the immediate vicinity of the flame. Feed 120, which includes the precursor medium, is introduced directly into the flame 114 through the burner 112. Fuel and oxidant for the flame 114 may be fed to the flame 114 as part of and/or separate from the feed 120. In a preferred embodiment, the liquid vehicle preferably present in the precursor medium acts as the fuel.

The flame reactor 106 also has a secondary zone 134 for aiding growth of the nanoparticles to attain a weight average particle size within the desired range. As shown in FIG. 2, the secondary zone is a volume within conduit 108 that is downstream from the primary zone 116. The secondary zone 134 will optionally be longer and occupy more of the internal reactor volume than the primary zone 116, and the residence time in the secondary zone 134 may be significantly larger than in the primary zone 116.

Optionally, an insulating material (not shown) surrounds and insulates the portion of the conduit 108 that includes the secondary zone 134. Additionally or alternatively, the secondary zone 134, or a portion thereof, is surrounded by a heater (not shown), which is used to input heat into the flowing stream while the flowing stream is within the secondary zone. The additional heat added to the secondary zone 134 by the heater, provides control to maintain the nanoparticles at an elevated temperature in the secondary zone that is higher than would be the case if the heater were not used. The heater may be any device or combination of devices that provides heat to the flowing stream in the secondary zone. For example, the heater may include one or more flames or may be heated by a flame or a circulating heat transfer fluid. In one embodiment, the heater includes independently controllable heating zones along the length of the secondary zone 134, so that different subzones within the secondary zone 134 may be heated independently. This could be the case for example, when the secondary zone is a hot wall tubular furnace including multiple independently controllable heating zones.

During operation of the flame spray system shown in FIG. 2, feed 120 of a precursor medium comprising precursors to the metal core and metal oxide shell in a liquid vehicle is introduced into primary zone 116 through burner 112. Oxidant and a fuel are also fed to the flame through burner 112 for combustion to maintain the flame 114. The oxidant and/or fuel may be fed to the burner 112 together with or separate from the feed 120. In the primary zone 116, the physicochemical phenomena that take place are in the following order: droplet evaporation, combustion of liquid vehicle and/or precursor, precursor reaction/decomposition, particle formation via nucleation, particle growth by coagulation and sintering and metal inversion form the surface to the core of the particles. Particle growth and metal inversion then continue into the secondary zone 134.
FIGS. 3 and 4 show modifications of flame reactor system shown in FIG. 2, in which the feed of the precursor medium is introduced into the primary zone 116 in different locations. In FIG. 3, feed 122 is introduced in the primary zone 116 directed toward the end of the flame 114, rather than through the burner 112 as with FIG. 2. In FIG. 4, feed of nongaseous precursor 126 is introduced into the primary zone 116 at a location adjacent to, but just beyond the end of the flame 114.
FIGS. 2 to 4 are only examples of how precursor mediums may be introduced into a flame reactor. Additionally multiple feeds of precursor medium may be introduced into the flame reactor 106, with different feeds being introduced at different locations, such as simultaneous introduction of the feeds 120, 122 and 126 of FIGS. 2 to 4.

Referring now to FIGS. 5 to 7, these illustrate a flame spray nozzle assembly suitable for use in the flame spray reactor shown in FIGS. 2 to 4. The spray nozzle assembly is shown generally at 932 and comprises a substantially cylindrical, atomizing feed nozzle 900 with outer walls 904, a proximal end 924 and a distal end 923. Extending longitudinally through the nozzle are a centrally disposed precursor feed conduit 907, an annular atomizing medium feed conduit 908 extending around and coaxial with the conduit 907 and a plurality of fuel/oxidant feed conduits 909 equiangularly spaced around the atomizing medium feed conduit 908 and the precursor medium feed conduit 907. Conveniently, the nozzle assembly also comprises one or more annular auxiliary conduits 934, which are disposed between the conduits 908 and 909 and which serve to supply auxiliary material to the reactor. The shape of the nozzle assembly is preferably substantially cylindrical, although the shape of the nozzle assembly may be of any suitable geometric shape (*e.g*., square and oval).

As shown in FIG. 5, the precursor medium feed conduit 907 has a diameter δ, the atomizing medium conduit 908 has a diameter γ, and the fuel/oxidant conduits 909 have a diameter ε. The precursor medium conduit 907 and the atomizing medium conduit 908 are separated by a distance η, whereas each fuel/oxidant conduit 909 and the precursor medium conduit 907 are separated by a distance λ The value of η must be such that the precursor medium conduit 907 is sufficiently close to atomizing medium conduit 908 so that the precursor medium that flows out of the precursor medium conduit is atomized by the atomizing medium that flows out of the atomizing medium conduit. The value of λ must be such that the flame formed from the ignition of the fuel/oxidant is sufficiently close to the precursor medium conduit so that the precursor medium is ignited by the fuel/oxidant flame during the flame spray process.

The value of δ controls (i) the size of the precursor medium droplets that flow out of the precursor medium feed conduit; and (ii) the amount of precursor medium that may be flame sprayed (i.e., throughput) according to the processes of the invention. The value of γ controls the amount of atomizing medium that may flow out of the atomizing medium conduit. The value of ε controls the volume and velocity of the fuel/oxidant that flows out of the fuel/oxidant conduit.

In operation, fuel/oxidant 916 is fed to the fuel/oxidant conduits 909 and flows from the proximal end 924 to the distal end 923 of the nozzle assembly. The fuel/oxidant is ignited, *e.g.*, with an additional pilot flame, as it exits the fuel/oxidant conduits 909 at the distal end 923, thereby forming a flame that directly heats the internal reactor volume 921. At the same time, atomizing medium 917 and precursor medium 918 are fed to atomizing medium conduit 908 and precursor medium conduit 907, respectively, and flow through, under pressure, from the proximal end 924 to the distal end 923 of the nozzle assembly. As the atomizing medium and the precursor medium exit the distal end of the nozzle assembly 923, the atomizing medium causes the precursor medium to atomize to form droplets as the precursor medium is introduced into the internal reactor volume 921. The atomized precursor medium is subsequently ignited by the burning fuel/oxidant mixture exiting the conduits 909.

In one embodiment, the atomizing feed nozzle 900 is surrounded by, and is in direct contact with, a sheath medium nozzle support structure 919 defined by an inner wall 912 and an outer wall 913. The sheath medium nozzle support structure comprises a plurality of substantially longitudinally extending sheath medium nozzles 915. As shown, the sheath medium nozzle support structure is formed of an annular plate with holes in it defining the sheath medium nozzles 915. The sheath medium nozzles 915 are in fluid communication with a sheath medium plenum 920, via sheath medium inlet 922. The sheath medium nozzle also comprises a sheath medium outlet 933 from which the sheath medium can flow into the internal reactor volume. Sheath medium plenum 920 is housed within a sheath medium plenum housing 927 comprising inner wall 926 and outer wall 925. Sheath medium feed 929 feeds into the plenum 920 via inlet 928 in the housing 927.

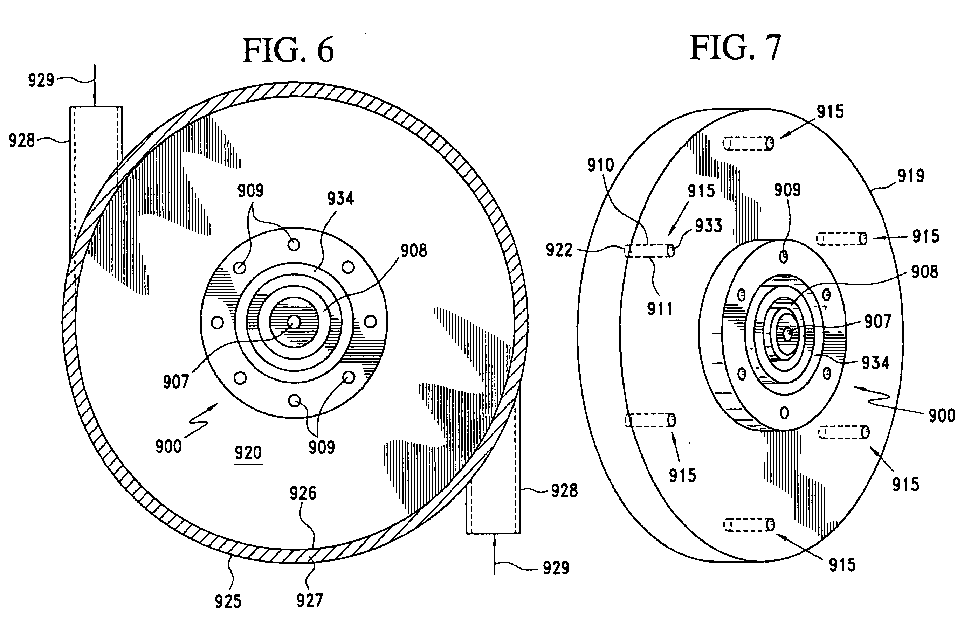

As shown in FIG. 6, the sheath medium plenum inlet 928 is preferably located on the sheath medium plenum housing 927 such that the sheath medium is introduced into the sheath medium plenum 920 tangentially, along the inner plenum housing wall 926. After its introduction, the sheath medium subsequently flows from the plenum 920, through sheath medium outlet 922 and into the internal reactor volume 921. One benefit of introducing the sheath medium tangentially along the inner plenum housing wall is that it allows uniform and even distribution of the sheath medium through the sheath medium nozzle support structure and around the flame.

### Preparation of compositions

The compositions used to form the photovoltaic conductive features of certain embodiments of the present invention can either be inks or pastes, depending on the method used for depositing the compositions on a substrate. The compositions preferably comprise the above-described metal-containing particles. Additionally, the compositions preferably comprise a vehicle. Optionally, the composition may also include one or more additives such as one or more dispersants.

Depending on the formulation, the compositions of the invention may be useful in a number of different printing methods, including, e.g., screen, lithographic, gravure, flexo, photopatterning, syringe, aerosol jetting, piezo-electric, thermal, drop-on-demand or continuous ink jet printing, preferably ink-jet printing or direct write printing. Although highly dependant on material and the specific printing process being implemented, in various embodiments, the particle loading in the compositions is at least about 2 % by weight, e.g., at least about 5 % by weight, at least about 10 % by weight, at least about 15 % by weight, at least about 20 % by weight, or at least about 50 % by weight, based on the total weight of the total composition. It is preferred for the total loading of the particles useful in the compositions used to form the photovoltaic conductive features of the present invention to be not higher than about 75 % by weight, e.g., not higher than about 40 % by weight, not higher than about 20 % by weight, not higher than about 10 % by weight, or not higher than about 5 % by weight, based on the total weight of the composition. In various embodiments, in terms of ranges, the composition comprises from about 1 wt % to about 60 wt. % metal-containing particles, e.g., from about 2 to about 40 wt. % metal-containing particles, from about 5 to about 25 wt. % metal-containing particles, or from about 10 to about 20 wt. % metal-containing particles, based on the total weight of the composition. In various other embodiments, the composition comprises from about 40 wt % to about 75 wt. % metal-containing particles, e.g., from about 40 to about 60 wt. % metallic particles, based on the total weight of the composition. Loadings in excess of the preferred loadings can lead to undesirably high viscosities and/or undesirable flow characteristics. Of course, the maximum loading that still affords useful results also depends on the density of the metal-containing particles. In other words, for example, the higher the density of the metal of the metal-containing particles, the higher will be the acceptable and desirable loading in weight percent.

The compositions preferably comprise a vehicle in addition to the metal-containing particles. In one embodiment, these compositions further comprise an anti-agglomeration substance, for example, a polymer or surfactant, as described above. The vehicle for use in the compositions is preferably a liquid that is capable of stably dispersing the metal-containing particles. For example, vehicles are preferred that are capable of affording a composition that can be kept at room temperature for several days or even one, two, three weeks or months or even longer without substantial agglomeration and/or settling of the metal-containing particles. To this end, it is also preferred for the vehicle to be compatible with the surface of the metal-containing particles. In one embodiment, the vehicle comprises (or predominantly consists of) one or more polar components (solvents) such as, e.g., a protic solvent, or one or more aprotic, non-polar components, or a mixture thereof. The vehicle, in an embodiment, is a solvent selected from the group consisting of alcohols, polyols, amines, amides, esters, acids, ketones, ethers, water, saturated hydrocarbons, unsaturated hydrocarbons, and mixtures thereof.

In some embodiments, the vehicle comprises a mixture of at least two solvents, optionally at least two organic solvents, e.g., a mixture of at least three organic solvents, or at least four organic solvents. The use of more than one solvent is preferred because it allows, inter alia, to adjust various properties of a composition simultaneously (e.g., viscosity, surface tension, contact angle with intended substrate etc.) and to bring all of these properties as close to the optimum values as possible. Non-limiting examples of vehicles are disclosed in, e.g., U.S. Patent Nos. 4,877,451; 5,679,724; 5,725,647; 5,837,041; 5,837,045 and 5,853,470, the entire disclosures of which are incorporated by reference herein. In another embodiment, the vehicle comprises water, optionally primarily water.

In some embodiments according to the present invention, the composition has a viscosity of greater than about 5,000 cP, e.g., greater than 7000 cP and greater than 10,000 cP. Compositions with the aforementioned viscosities are particularly useful in the optional screen-printing embodiments of the present invention. In other embodiments, the composition has a viscosity of less than about 100 cP, e.g., less than about 50 cP, less than about 10 cP, less than about 5 cP and less than about 1 cP. In still other embodiments, the composition has a viscosity of from about 50 cP to about 300 cP, e.g., from about 50 cP to about 200 cP and from about 50 to about 100 cP. In some embodiments according to the first aspect of the present invention, the composition has a surface tension of from about 20 dynes/cm to about 60 dynes/cm, e.g., from about 20 dynes/cm to about 40 dynes/cm. The viscosities and surface tensions used herein are at 25°C.

The compositions comprising the metal-containing particles optionally further comprise one or more additives, such as, but not limited to, buffers, polymers, resins (e.g., 20 wt% of an ethyl cellulose solution in terpineol), dispersants, thickeners, adhesion promoters, rheology modifiers, surfactants (ionic, non-ionic, anionic, cationic, zwitterionic surfactants including ions comprising a sulfate ion, sulfonate ion, carboxylate ion, phosphate ion, ammonium ion or a phosphonium ion; a non-limiting example of a surfactant is sodium dilaureth phosphonate 10 (DLP-10)), wetting angle modifiers, humectants (e.g., glycerol, ethylene glycol, 2-pyrrolidone, and 1,5-pentanediol), crystallization inhibitors (e.g., 29,000 MW PVP), binders, dyes/pigments and the like. Non-limiting examples of adhesion promoters include shellac, latex, acrylates, other polymers, metal or a main group oxide (e.g., SiO₂, CuO). Additional examples of adhesion promoters are described in U.S. Pat. No. 5,750,194, which is herein fully incorporated by reference. Non-limiting examples of rheology modifiers include SOLTHIX 250 (Lubrizol), SOLSPERSE 21000 (Lubrizol), styrene allyl alcohol (SAA), ethyl cellulose, carboxy methylcellulose, nitrocellulose, polyalkylene carbonates, ethyl nitrocellulose, and the like.

Non-limiting examples of binders include latex, shellac, acrylates, and the like. Furthermore, polymers such as, but not limited to, e.g., polyamic acid polymers, acrylic polymers, PVP, co-polymers of PVP (alkanes, styrenes, etc.), polyfluorosilicate polymers, polyflourinated telomers (including Zonyl^{™} products manufactured by E.I. DuPont de Nemours & Co.), and co-polymers of styrene acrylics (e.g., those sold under the Joncryl^{™} trade name available from Johnson Polymer Corp.) can improve the adhesion of the metallic particles and/or metallic nanoparticles to a polymer substrate, as can substances such as coupling agents (e.g., zinc oxides, titanates and silanes). These substances can function to increase adhesion of the feature to the substrate, as well as to decrease the interaction of water with the feature thereby rendering the feature more durable. Cohesion promoters may also be included in the ink to improve reflective feature durability.

Non-limiting examples of dispersants for use in polar and nonpolar liquid media include: polymers, ionic dispersants, non-ionic dispersants, co-polymers, block co-polymers, acrylics, styrene acrylics, styrenic dispersants, polyesters, copolymers of polyethers and polycarbonates, ammonium salt of polyacrylic acid; ammonium salt of a styrene acrylic polymers; polymeric carboxylic acid; sodium salt of a polymeric carboxylic acid; anionic macromolecular surfactant, condensed naphthalene sulfonic acid; methyl hydroxyethyl cellulose; anionic and nonionic surfactants; polycarboxylic acid surfactant; polyoxyethylenesorbitan fatty acid ester; polyoxyethylene sorbitan monooleate; polyoxyethylene sorbitan monostearate; salts of polyfunctional oligomer; sodium dodecyl benzene sulfonate; sodium or ammonium salt of a sulfate ester an alkylphenoxypoly(ethyleneoxy)ethanol; sodium salt of a carboxylated polyelectrolyte; sodium salt of condensed naphthalene sulfonate; sodium salt of disulohonic acids; sodium salt of polyacrylic acids polyacrylic acids; sodium salt of polymerized alkyl naphthalene sulfonic acid; sodium salt of polymerized alkyl-aryl sulfonic acid; sodium salts of polymerized substituted alkyl-aryl sulfonic acids; sodium salts of polymerized substituted benzoid alkyl sulfonic acids; sodium tetraborate; ammonium salt of carboxylated polyelectrolyte alkylphenol ethoxylates; condensation product of naphthalene sulfonic acid formaldehyde; condensation product sulfo-succinic acid ester of an alkoxylated novolak; nonylphenol novolak ethoxylate; condensation product of cresol-formaldehyde-schaffer salt; sodium salt of a cresol-formaldehyde condensation product; fatty acid methyl tauride sodium salt; phosphate of EO-PO-EO blockpolymer; 2,4,6-Tri-(1-phenylethyl)-phenol polyglycol ether phosphoric acid ester; 2,4,6-Tri-1(1-phenylethyl)-phenol polyglycol ether monophosphate triethanolamine salt; tri-sec,-butylphenol polyglycol ether phosphoric acid ester with 4 EO; alkyl polyglycol ether phosphoric acid ester with 6 EO; alkyl polyglycol ether phosphoric acid ester with 8 EO; 2,4,6-Tri-(1-phenylethyl)-phenol polyglycol ether sulfate ammonium salt; sulfosuccinic ester of ethoxylated castor oil; mannitol; sodium lauryl sulfate; and mono & disaccharides. EO-PO- acrylic polymers, sodium or ammonium salts. In some embodiments, the dispersant is selected from the group consisting of an ammonium salt of polyacrylic acid; an ammonium salt of styrene acrylic polymer; a sodium salt of condensed naphthalene sulfonate; a sodium salt of polymerized alkyl naphthalene sulfonic acid; a phosphate of an EO-PO-EO block polymer; a sodium salt of an EO-PO- acrylic polymer; and an ammonium salt of an EO-PO- acrylic polymer. In a preferred embodiment, the dispersant comprises polyvinyl pyrrolidone (PVP).

In some embodiments, the composition comprises 1-20 wt% metal-containing particles, (e.g., 1-10 wt%, 5-20 wt%, and 5-15 wt%), 0.1-5 wt% polyvinyl pyrrolidone (e.g., 0.1-1 wt%, 1-5 wt%, and 2-5 wt%; average MW = 29,000), 40-80 wt% water (e.g., 40-50 wt%, 40-60 wt%, and 50-80%), 0 to 50 wt% glycerol (e.g., 0-20 wt%, 10-40 wt%, and 20-50 wt%), and 0.01-1.5 wt% DLP-10 (e.g., 0.01-1 wt%, 0.5-1.5 wt%, and 0.9-1.5 wt%).

Additionally, the compositions can optionally be formulated according to the methods described in U.S. Patent Nos.: 5,662,286; 5,624,485; 4,567,213; 4,390,369; 5,662,736; 5,596,027; 5,786,410; 5,643,356; 5,642,141, the entireties of which are incorporated herein by reference. Also, the compositions can optionally be formulated according to the methods described in published PCT Application No. WO94/03546, the entirety of which is incorporated herein by reference. Finally, the compositions can optionally be formulated according to the methods described in European Patent Application Nos. EP0745479; EP0805192; EP0745651; and EP0952195, the entireties of which are incorporated herein by reference. In an optional embodiment, the compositions can be formulated by using, in combination, water (40-80 wt%), glycerol (0-60 wt%), surfactant (0-10 wt%; e.g., DLP-10), and buffer (0-2 wt%; e.g., ammonium hydroxide). The compositions can also optionally be formulated by using, in combination, water (84 wt%), 2-pyrrolidinone (2 wt%), urea (0.2 wt%), glycerin (2.1 wt%), diethylene glycol (7.5 wt%) and SURFYNOL^{®} 104E (0.2 wt%). The compositions can also optionally be formulated by using, in combination, water (85 wt%), 2-pyrrolidinone (2 wt%), glycerin (2 wt%), diethylene glycol (2 wt%), and isopropyl alcohol (5 wt%).

The composition comprising the metal-containing particles according to the present invention can be deposited and converted to a photovoltaic conductive feature at low temperatures, thereby enabling the use of a variety of substrates having a relatively low melting or decomposition temperature. The types of substrates that are particularly useful according to the present invention include polyfluorinated compounds, polyimides, epoxies (including glass-filled epoxy), polycarbonates and many other polymers. In some embodiments, substrates can also include cellulose-based materials such as wood or paper, acetate, polyester, polyethylene, polypropylene, polyvinyl chloride, acrylonitrile, butadiene (ABS), flexible fiber board, non-woven polymeric fabric, cloth, metallic foil and thin glass. Particularly preferred substrates include p-silicon wafers.

### Photovoltaic conductive feature: formation and properties

After deposition onto a substrate, the composition comprising the metal-containing particles is treated such that the composition forms at least a portion of a photovoltaic conductive feature. The treatment can include multiple steps, or can occur in a single step, such as when the composition is rapidly heated and held at the conversion temperature for a sufficient amount of time to form the photovoltaic conductive feature. Heating can be accomplished using furnaces, light sources such as heat lamps and/or lasers. The photovoltaic conductive feature can be post-treated after its formation. For example, the crystallinity of the phases present can be increased, such as by laser processing. The post-treatment can also include cleaning and/or encapsulation of the electronic features, or other modifications.

In some embodiments, the treatment that forms the photovoltaic conductive feature involves heating the composition to a temperature from about 400°C to about 1000°C, e.g., from about 700°C to about 1000°C, from about 400°C to about 700°C, to form the photovoltaic conductive feature on the substrate. Heating of the composition at the aforementioned temperatures causes the metal-containing particles to sinter, thus affording a percolation network of metallic particles. The resulting photovoltaic feature thus comprises not only a percolation network of metallic particles, but also a ceramic material.

In some embodiments the photovoltaic conductive feature is deposited on a substrate that comprises a layer, e.g., a passivating layer such as a silicon nitride layer on a p-silicon wafer, that can be etched by the ceramic material present on the metal-containing particles during the heating of the composition. In these embodiments, the photovoltaic conductive feature, comprises:
(a) a percolation network of metallic particles in electrical contact with a silicon-containing substrate, the metallic particles comprising a metal; and
(b) a ceramic material.

The compositions and processes of the invention provide the ability to form photovoltaic features having a lower ceramic content than in conventional photovoltaic conductive features. In preferred embodiments, the ceramic material is present in the conductive feature in an amount less than 5 wt. %, e.g., less than 3 wt%, less than 2 wt%, and less than 1 wt%. As a result of the comparatively low ceramic content, the compositions and processes of the invention provide the ability to form photovoltaic conductive features having improved conductivity over conventional photovoltaic conductive features. For example, in some exemplary preferred embodiments, the percolation network has a resistance that is less than five times the bulk resistance of the metal, e.g., less than three times, less than two times, or less than one and a half times the bulk resistance of the metal. In some embodiments, the percolation network has a resistance that is less than 8 µΩ•cm, e.g., less than 5 µΩ•cm, or less than 2 µΩ•cm.

In some embodiments according to the second aspect of the present invention, the conductive feature has a thickness greater than 1 µm, e.g., greater than 5 µm. Such thick conductive features may be formed, for example, by printing the composition in multiple passes. In other embodiments, the conductive feature has a thickness of from about 50 nm to about 1 µm, e.g., from about 50 nm to about 200 nm, and from about 100 nm to about 500 nm. In some embodiments, the conductive feature comprises a set of finger lines and collector lines deposited essentially at a right angle to the finger lines. When certain printing processes are employed (e.g., ink jet printing processes), conductive features may be formed having comparatively thin line widths. In some embodiments, for example, either or both the parallel finger lines or the collector lines have a width less than 200 µm, e.g., less than 100 µm.

The metal comprised in the photovoltaic conductive features of the embodiments of the present invention optionally is selected from silver, copper, gold, palladium, platinum, nickel, cobalt, zinc, molybdenum, tungsten, and alloys thereof. In some embodiments, the metal is selected from ruthenium, titanium, and alloys thereof. The ceramic material comprised in the photovoltaic conductive features of the embodiments of the present invention is selected the ceramic material comprises a mixture of a plurality of metal oxides, e.g., an oxide of at least one element selected from silicon, zinc, zirconium, aluminum, titanium, ruthenium, tin and cerium. In other embodiments, the ceramic material comprises two or more oxides of at least one element selected from silicon, zinc, zirconium, aluminum, titanium, ruthenium, tin and cerium. In still other embodiments, the ceramic material comprises an oxide of at least one element selected from lead, strontium, sodium, calcium, bismuth, and boron. In other embodiments, the ceramic material comprises two or more oxides of at least one element selected from lead, strontium, sodium, calcium, bismuth, and boron. Preferably, said metal is silver and said ceramic material is silica.

### Uses

Depending on the metal and ceramic employed, the coated particles described herein have a wide variety of potential uses including in optical, electronic, fuel cell as well as in the above-describe photovoltaic applications.

In one embodiment, non-limiting uses for the coated particles of the invention include anti-counterfeiting and graphic applications such as those described in U.S. Serial No. 11/331,233 filed January 13, 2006, U.S. Serial No. 11/443,248 filed May 31, 2006, U.S. Serial No. 11/443, 264 filed May 31, 2006, U.S. Serial No. 11/443,303 filed May 31, 2006, and U.S. Serial No. 11/443,304 filed May 31, 2006, all of which are fully incorporated herein by reference.

In another embodiment, non-limiting uses for the coated particles of the invention include their use in electronic and printable electronic and display applications such as in conductors, resistors, dielectrics, capacitors, and the like, in for example various circuits, solar panels, plasma televisions, cell phones, laptops, and the like, as described in for example, U.S. Serial No. 11/443,131 filed May 31, 2006, U.S. Serial No. 11/331,231 filed January 13, 2006, U.S. Serial No. 11/331,186 filed January 13, 2006, U.S. Serial No. 11/331,237 filed January 13, 2006, U.S. Serial No. 11/331,190 filed January 13, 2006, U.S. Serial No. 11/331,239 filed January 13, 2006, U.S. Serial No. 11/331,187 filed January 13, 2006 and U.S. Serial No. 10/265,179 filed October 4, 2002, all of which are fully incorporated herein by reference.

In yet another embodiment, non-limiting uses for the coated particles of the invention include their use as electrocatalysts for use in fuel cell applications such as for example those described in U.S. Serial No. 11/328,147, filed January 10, 2006, U.S. Serial No. 10/417,417 filed April 16, 2003, U.S. Serial No. 11/081,768 filed March 15, 2005, and U.S. Serial No. 11/081, 765 filed March 15, 2005, and U.S. Patent Nos. 6,103,393, 6,660,680, and 6,967,183, all of which are fully incorporated herein by reference.

The present invention will now be further described with reference to the following non-limiting Examples.

### Examples 1 to 8

Silver neodecanoate- and hexamethyldisiloxane (HMDS) are premixed in toluene in differing amounts to produce test solutions having various Ag/SiO₂ weight ratios between 5/95 and 98/2 (see Table 1 below). Each solution is dispersed in an oxygen dispersion gas flowing at 40 slpm and supplied to a flame spray reactor similar to that shown in FIGS. 5 to 7 at a rate of 10 ml/minute. The ignition source for the reactor is a pilot flame fueled by methane supplied at 2 slpm and oxygen supplied at 4 slpm, whereas the fuel for the burner(s) is supplied by the precursors (silver neodecanoate and HMDS) and the toluene carrier. In addition, the reactor includes an oxygen sheath supplied at 200 slpm and an oxygen quench medium supplied at 900 slpm. The nozzle tip diameter (δ in FIG. 5) is 0.5 mm.

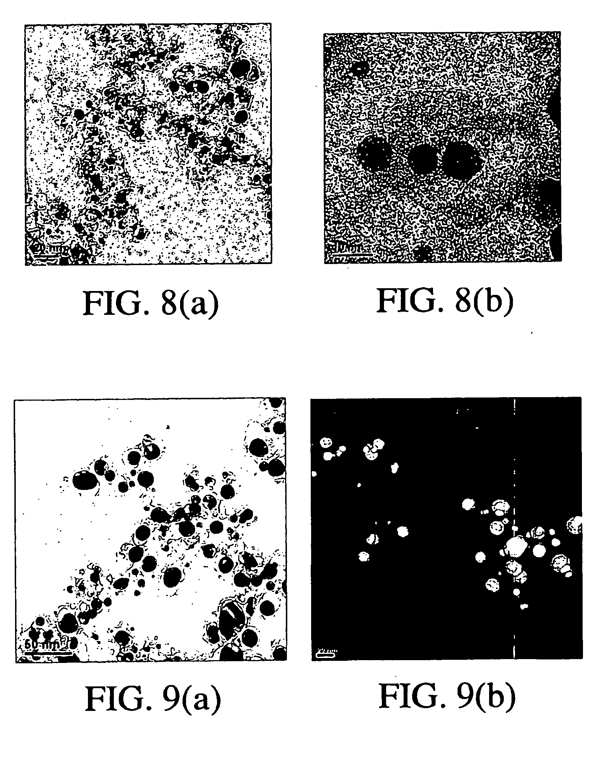

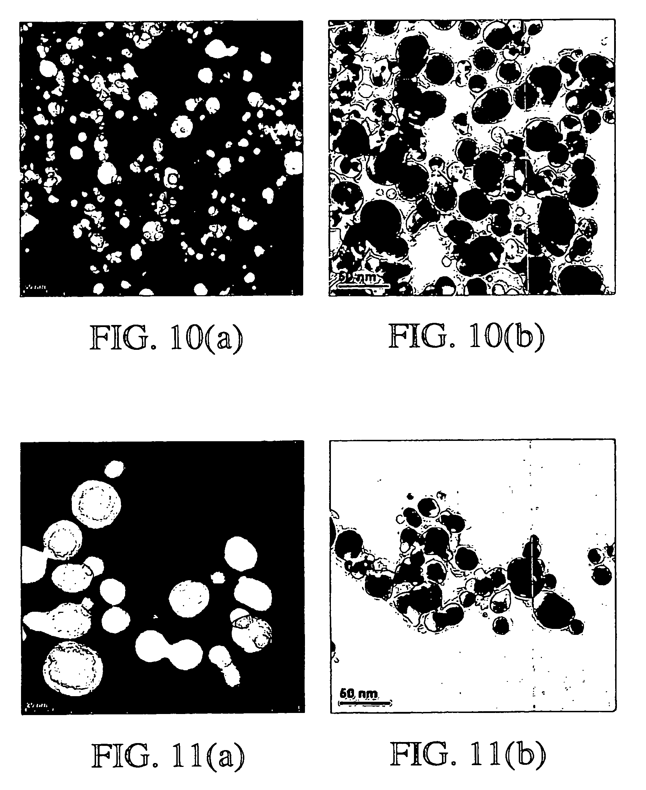

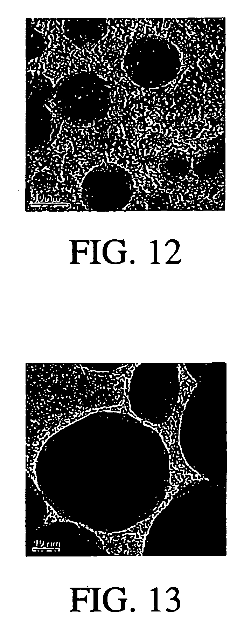

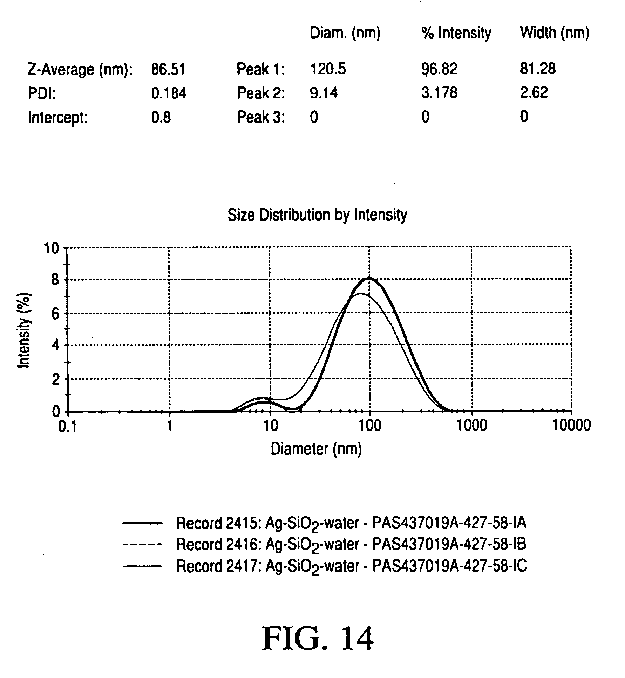

The resulting product is collected on a baghouse filter and analyzed using transmission electron microscopy (TEM), scanning transmission electron microscopy (STEM), quasi-electric light scattering (QELS) and other analytical measurements. The results of the TEM and STEM analyses for the products of Examples 4 to 8 are shown in FIGS. 8 to 13. It is unexpectedly found that the Ag/SiO₂ ratio in the precursor mixture dramatically affects the properties of the final product. For low Ag/SiO₂ precursor ratios (less than 20 wt% Ag), the resulting product is composed of a mixture of separate SiO₂ and Ag particles with some composite particles of Ag/SiO₂. At higher Ag/SiO₂ precursor ratios (greater than or equal to 60 wt% Ag), the product unexpectedly shows unique morphology with small particles (20 to 60 nm) of Ag encapsulated in SiO₂ coating. As shown in FIG. 14, QELS demonstrates the higher Ag/SiO₂ ratio products to have a relatively narrow particle size distribution centered near 100 nm with substantially no particles being larger than about 500 nm.

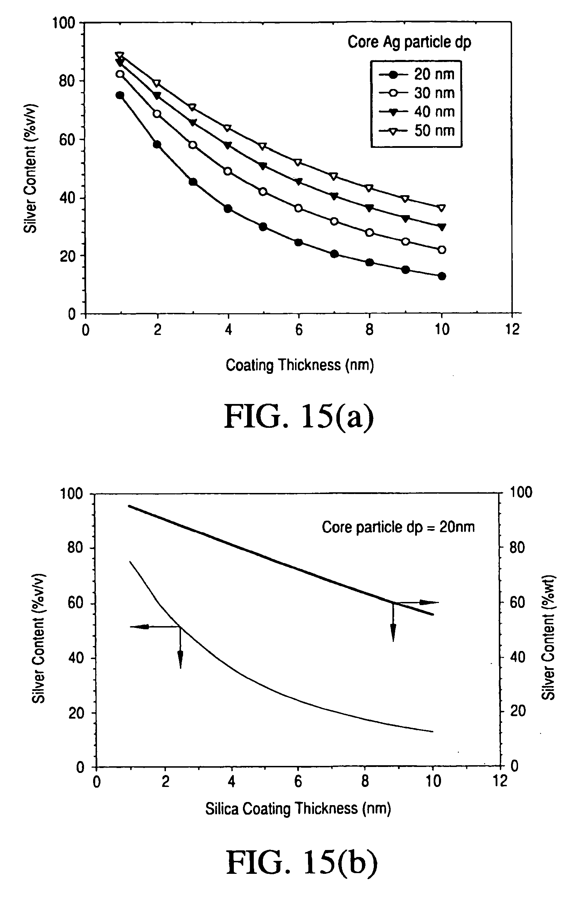

It is also found that the thickness of SiO₂ coating and size of Ag particles can be controlled by adjusting the Ag/SiO₂ ratio and processing conditions. The relationship between coating layer thickness and required amount of SiO₂ coating material is shown in FIG. 15 (a). Because of the density difference between silver (10 g/cm³) and silica (2.2 g/cm³), a very small concentration of silica is required to achieve substantial coverage of the silver. This is shown in FIG. 15 (b) where the silver concentration in the composite Ag/SiO₂ particles is plotted against coating thickness for an Ag core particle with a weight average particle size of 20 nm. In this example, less than 7 %wt of SiO₂ is required to provide a 1 nm coherent layer over the 20 nm silver particles. The larger the diameter of the silver core particles the lesser the amount of silica required to achieve the same coating layer thickness.

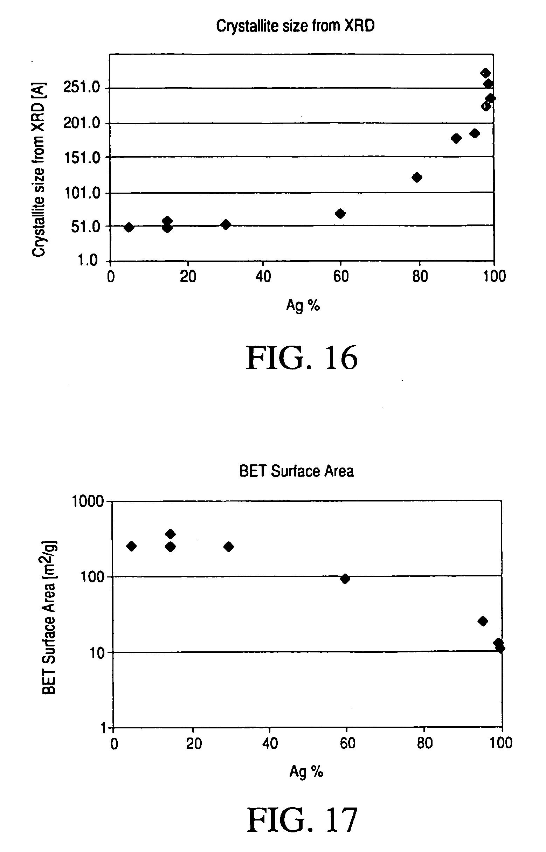

FIG. 16 illustrates the effect of the silver loading (in weight %) in the final particulate product on the XRD crystallite size of the silver in the product. It will be seen from FIG. 16 that the XRD crystal size of the Ag in the final product increases with increasing weight % of silver. For silver loadings below 80%, the crystal size is <10 nm and not significantly affected by the increase in silver loading. At higher loadings (>80%), the crystal size strongly depends on silver loading increasing to ∼25 nm for 99% silver loading.

FIG. 17 illustrates the effect of the silver loading (in weight %) in the final particulate product on the BET surface area of the final particulate product. FIG. 17 shows that the specific surface area of the final product changes only slightly as the weight% of silver is increased from 5% to 60%. For those low loadings of Ag, the properties of the final product are dominated by the properties of Si02 - thus high surface area as measured by BET. At higher Ag loading and in particular for Ag loading >80%, the properties of the final product are dominated by the properties of silver, which results in significant decrease of the specific surface area measured by BET."

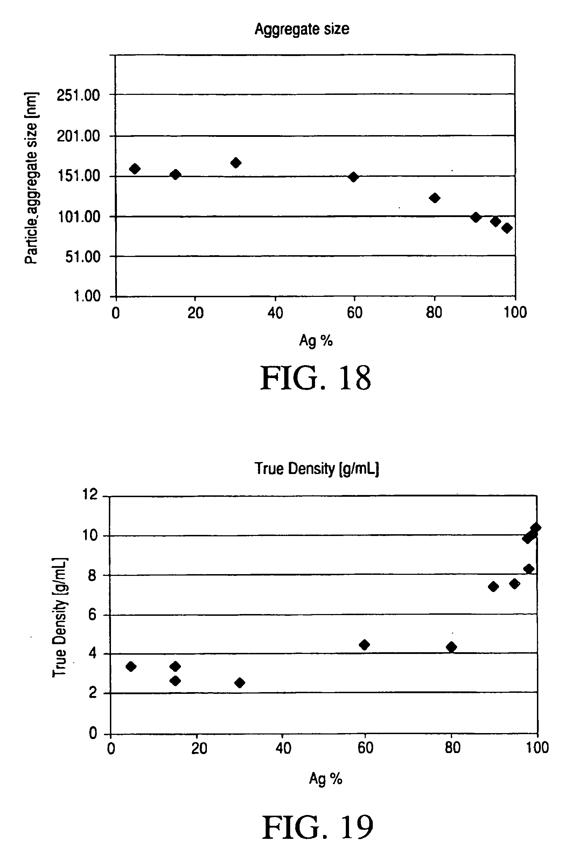

FIG. 18 illustrates the effect of the silver loading (in weight %) in the final particulate product on the size of the silver aggregates in the final particulate product and shows a slight drop in aggregate size from about 150 nm to about 100 nm as the silver loading increases form 20 wt% to 98 wt%.

FIG. 19 illustrates the effect of the silver loading (in weight %) in the final particulate product on the density of the final particulate product and shows that the density tends to increase as the silver loading increases.

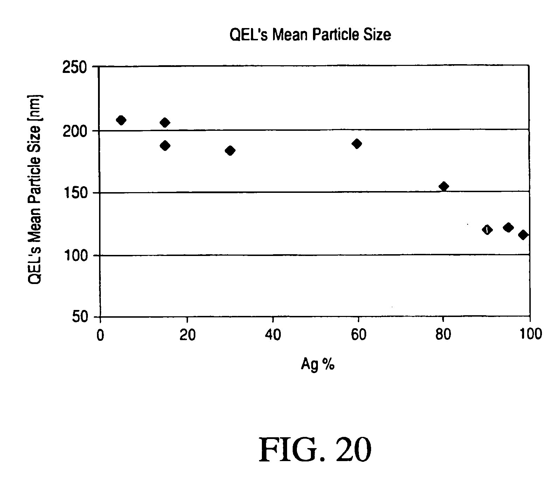

FIG. 20 illustrates the effect of the silver loading (in weight %) in the final particulate product on the mean particle size of the final particulate product as determined by QELS and shows a decrease in mean particle size from about 200 nm to about 120 nm as the silver loading increases form 20 wt% to 98 wt%.

Each of the powder products is formulated in a water-based ink that can be easily ink-jetted to produce printed features having the reflectivity indicated in Table 1.

**Table 1**

| **Example** | **Precursor Comp. Ag %wt/SiO₂ wt%** | **Vol.% SiO₂ in Nanoparticles** | **Reflectivity of Printed Feature** |
|---|---|---|---|
| 1 | 5 | | Non-reflective |
| 2 | 15 | 96 | Non-reflective |
| 3 | 30 | 91 | Non-reflective |
| 4 | 60 | 75 | Non-reflective |
| 5 | 80 | 53 | |
| 6 | 90 | 33 | Partially reflective |
| 7 | 95 | 20 | Reflective |
| 8 | 98 | 8.5 | Reflective |

### Example 9

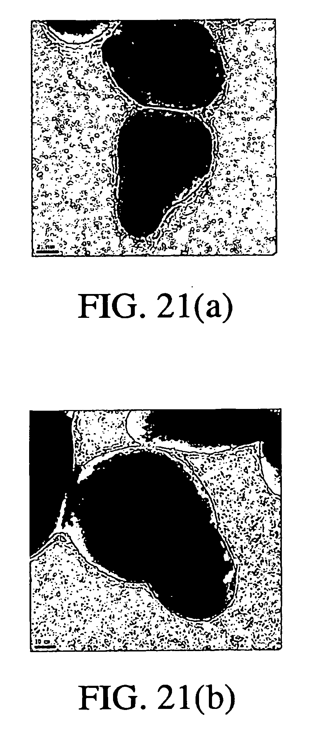

Particles with Ag:SiO₂ weight ratios of 90:10, 98:2, 99:1, and 99.5:0.5 are produced using the same procedure as in Examples 1-8 above. The first three materials (90:10, 98:2, 99:1) are easily dispersible in water and QEL's measurements indicate a mean particle size of ∼100 nm. However, 99.5:0.5 material is not easily dispersible and QELS measurements indicate the presence of particles that are greater than 100 microns as well as a population of particles around 100 nm. This suggests that some of the silver particles produced in the process are coated by SiO₂ which prevents their aggregation. However, other Ag particles are insufficiently (or not at all) coated with SiO₂ which results in their aggregation or agglomeration into larger particles that rapidly settle when dispersed. FIGS. 21 (a) and (b) show TEM images of the 99.5:0.5 material - some particles appear coated with very thin layer of SiO₂ while others are fused together.

### Example 10 (Comparative)

The following example describes two metal/metal oxide material systems that do not result in production of coated metal particles. Silver neodecanoate and zinc ethylhexanoate precursors are premixed in toluene in differing amounts to produce test solutions having various Ag/ZnO weight ratios between 90/10 and 95/5. Each solution is dispersed in an oxygen dispersion gas flowing at 40 slpm and supplied to a flame spray reactor similar to that shown in FIGS. 5 to 7 at a rate of 10 ml/minute. The ignition source for the reactor is a pilot flame fueled by methane supplied at 2 slpm and oxygen supplied at 4 slpm, whereas the fuel for the burner(s) is supplied by the precursors (silver neodecanoate and Zn ethylhexanoate) and the toluene carrier. In addition, the reactor includes an oxygen sheath supplied at 200 slpm and an oxygen quench medium supplied at 900 slpm. The nozzle tip diameter is 0.5 mm.

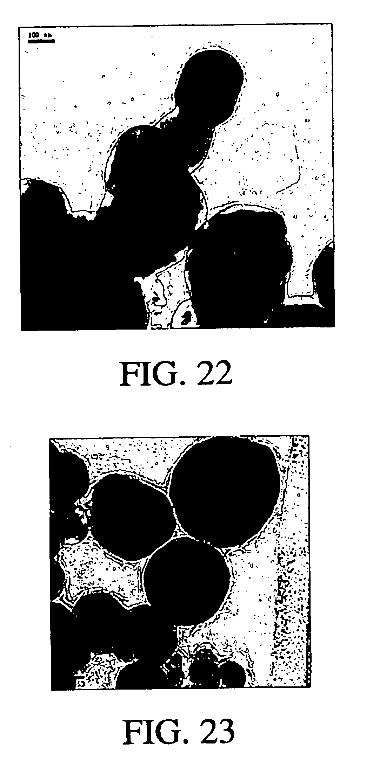

The resulting product is collected on a baghouse filter and analyzed using transmission electron microscopy (TEM), scanning transmission electron microscopy (STEM), quasi-electric light scattering (QELS) and other analytical measurements. The results of the TEM analyses for the Ag/ZnO=90:10 products are shown in FIG. 22. It is found that unlike SiO₂, ZnO does not form a coating/matrix that encapsulates the Ag particles. TEM images indicate that Ag particles are fused together with no ZnO coating separating them. Instead, ZnO appears in the form of separate larger crystalline particles. When Ag/ZnO material is dispersed in water using same procedure used to successfully disperse Ag/SiO2, the material does not disperse easily and particle size measured by QELS is > 3µm. These Ag/ZnO particles settle very quickly.

### Example 11

This example describes production of Ag/SiO₂ particles from inexpensive and readily available precursors. Ag nitrate and hexamethyldisiloxane (HMDS) are premixed in mixture of ethanol and ethylene glycol to produce solutions having various Ag/SiO₂ weight ratios between 95:5 and 99:1 and 98/2. Each solution is dispersed in an oxygen dispersion gas flowing at 40 slpm and supplied to a flame spray reactor similar to that shown in FIGS. 5 to 7 at a rate of 20 ml/minute. The ignition source for the reactor is a pilot flame fueled by methane supplied at 2 slpm and oxygen supplied at 4 slpm, whereas the fuel for the burner(s) is supplied by the precursors (silver nitrate and HMDS) and the ethanol/ethylene glycol carrier. In addition, the reactor includes an oxygen sheath supplied at 200 slpm and an oxygen quench medium supplied at 900 slpm. The nozzle tip diameter is 0.5 mm.

The resulting product is collected on a baghouse filter and analyzed using transmission electron microscopy (TEM), scanning transmission electron microscopy (STEM), quasi-electric light scattering (QELS) and other analytical measurements. The results of the TEM analyses are shown in FIG. 23. The resulting Ag/SiO₂ product synthesized from silver nitrate precursors shows similar unique morphology to that produced using silver neodecanoate precursors. As shown in FIG. 23, the Ag/SiO₂ produced made from nitrates consists of small particles (20 to 60 nm) of Ag encapsulated in SiO₂ coating. TEM images indicate that SiO₂ coating for product made from nitrate precursors could be somewhat less homogeneous than for products made from other precursors. However, both the 99:1 and 90:10 Ag:SiO₂ produced using AgNO3 precursor easily disperses in water and the QELS measurements show average size of 140 nm. This mixture remains well dispersed after standing over night with no obvious sediment.

### Example 12

Ink 1: silver-silica particles were dispersed in water at 10% by mass by means of a Branson ultrasonic horn. PVP (MW 29000) was added to this dispersion at approximately 5% by mass relative to powder mass. Dispersion with PVP was mixed via an ultrasonic bath for 5 minutes. Glycerol was added to dispersion and mixed via vortex mixer for about 1 minute and the ink was mixed in an ultrasonic bath for 10 minutes. The final composition was approximately 9.0 wt% silver-silica particles, 0.5 wt% PVP, 9.9 wt% glycerol, 80.6 wt% water. The ink was filtered through a 1.2 µm glass microfiber syringe filter, then through a 1.5 µm nylon syringe filter.

### Example 13

Inks 2A, B: Similar inks to 1 were produced with other humectants substituted for glycerol. For ink 2A, 2-pyrrolidone was used instead of glycerol. The final composition was approximately 9.9 wt% silver-silica particles, 0.4 wt% PVP, 10.0 wt% 2-pyrrolidone, 79.7 wt% deionized water. For ink 2B, 1,5-pentanediol was used instead of glycerol. The final composition was approximately 9.9 wt% silver-silica particles, 0.4 wt% PVP, 10.0 wt% 1,5-pentanediol, 79.7 wt% deionized water. Both inks were processed with a vortex mixer and sonic bath and filtered through 0.7 µm glass syringe filter.

### Example 14

Ink 3A: a similar ink to ink 1 was produced. The compositions was approximately 9.9 wt% silver-silica, 0.4 wt% PVP, 10.0 wt% glycerol, 79.7 wt% deionized water. The components were mixed by vortex mixer and then in an ultrasonic bath for 10 minutes. The ink was filtered through a 0.7 µm glass syringe filter.

### Example 15

Ink 4: silver-silica particles previously modified with ethylene oxide functional siloxane (Gelest 2-methoxy(polyethyleneoxy) propyltrimethoxysilane) were dispersed in aqueous KOH solution of pH=11.1 at a loading of 20 wt% and dispersed via a Branson ultrasonic horn. DLP-10 surfactant, water, and glycerol were added to produce an ink for workability in a piezoelectric inkjet head. The final composition was approximately 5.0 wt% silver-silica particles, 39.9 wt% water, 54.9 wt% glycerol, 0.2 wt% DLP-10 with some small percentage of siloxane and KOH. The ink exhibited a viscosity of 8.6 cP by measurement with a Brookfield viscometer at 24.7° C. Surface tension was measured at 34.7 mN/m by using a Kruss K-100 tensiometer with Wilhelmy plate at 24.4° C. The ink was filtered with a 0.45 µm polyvinylidine difluoride (PVDF) syringe filter.

### Example 16

Ink 5: a silver-silica particle dispersion in water was achieved at a relatively high loading of 50 wt% through use of an ultrasonic horn. PVP (29,000 MW) was added to the dispersion representing about 5 wt% relative to silver-silica particle powder, vortex mixed for about 1 minute, and agitated in an ultrasonic bath for 10 minutes. To this dispersion, DLP-10 and glycerol were added to form an ink for deposition through a Dimatix inkjet head. The final composition was approx 44.3 wt% silver-silica particles, 8.9 wt% glycerol, 0.2 wt% DLP-10, 2.3 wt% PVP, and 44.3 wt% deionized water. The viscosity of the ink was measured as 5.8 cP by a Brookfield HVDV II+ viscometer at 24.9° C. Surface tension of the ink was 34.4 mN/m at 23.3° C as measured with a Kruss K100 tensiometer using a Wilhelmy plate technique. Silver loading was conformed with two measurements of 45.1, and 45.2 wt% silver by a dissolution and titration technique.

### Example 17

Ink 6: A highly loaded ink similar to ink 5 was produced from a 55 wt% dispersion of silver-silica particles. In this case, the initial dispersion was made at 60 wt% silver-silica particles. PVP (29,000 MW)was added at 5 wt% relative to powder and the dispersion was allowed to sediment in 50 mL vials for 48 hours and decanted via a syringe in order to separate the largest of the particle size distribution. The dispersion was filtered through several 0.7 µm glass microfiber syringe filters. The dispersion was modified with DLP-10, and glycerol. The final composition was approximately 44 wt% silver-silica particles, 20.0 wt% glycerol, 0.1 wt% DLP-10, 2.3 wt% PVP, and 33.6 wt% deionized water. The viscosity of the ink was measured as 11.4 cP by a Brookfield HVDV II+ viscometer at 25.0°C. Surface tension of the ink was 34.9 mN/m at 23.2°C as measured with a Kruss K100 tensiometer using a Wilhelmy plate technique. Ink density was measured as 1.82 g/mL with an ink density cup.

### Example 18

Aging Experiment: aqueous silver-silica particle dispersions with PVP were made into inks with various other additives for humectants, surfactants, and pH modifiers. Inks were tested for aging characteristics at around 16-21 days and 43-44 days. Aging was characterized by comparing the particle size by quasielastic light scattering on a Malver Zetasizer instrument, and large particle count on an Accusizer. The main humectants chosen were glycerol, ethylene glycol, and polyethylene glycol 200 (PEG 200). Inks with the best aging characteristics were inks with polyethylene glycol 200 as a humectant. These inks showed no noticeable aging and were comparable to silver-silica dispersion with PVP cap, whereas glycerol and ethylene glycol containing inks showed particle growth by 44-45 days. An exception was an ink with the combination of glycerol, DLP-10 and ammonia. The combination of DLP-10 and higher pH appears to slow particle growth.

### Example 19

Ink 7: Based on foregoing aging results, an ink was formulated using PEG-200 as a humectant. SURFYNOL^{®} 440 was used to lower surface tension of the ink. The ink was formulated using a 15.5 wt% dispersion of silver-silica particles dispersed in water. The final formulation was approx 8.27 wt% silver-silica particles, 0.41 wt% 29000 MW PVP, 0.36 wt% SURFYNOL^{®} 440, 46.3 wt% PEG 200, and 46.3 wt% deionized water. The viscosity of the ink was measured as 8.4 cP by a Brookfield HVDV II+ viscometer at 25.0°C. Surface tension of the ink was 33.5 mN/m at room temp as measured with a Kruss K100 tensiometer using a Wilhelmy plate technique. Ink density was measured as 1.17 g/ml with an ink density cup at room temperature. The pH of the ink was 5.5. The z-average particle size as measured by Malvern Zetasizer was 133.8 nm. The large particle count of the ink >0.56 µm/0.1 mL was 5.5x10⁷ and the count >1.0 µm/0.1 mL was 1.4x10⁵.

### Example 20

Ink 8: A similar ink to 7 was made using a more concentrated base dispersion of 61.4 wt% with a smaller particle size distribution and smaller large particle count. The z-average particle size of the dispersion as measured by Malvern Zetasizer was 97.8 nm. The large particle count of the dispersion >0.56 µm/0.1 mL was 7.9x10⁶ and the count >1.0 µm/0. mL was 1.8x10⁴. The final formulation was approx 8.53 wt% silver-silica particles, 0.43 wt% 29000 MW PVP, 0.36 wt% SURFYNOL^{®} 440, 46.36 wt% PEG 200, and 44.32 wt% deionized water. The viscosity of the ink was measured as 8.5 cP by a Brookfield HVDV II+ viscometer at 24.8°C. Surface tension of the ink was 33.95 mN/m at room temp as measured with a Kruss K100 tensiometer using a Wilhelmy plate technique. Ink density was measured as 1.17 g/ml with an ink density cup at room temperature. The pH of the ink was 5.8. The z-average particle size as measured by Malvern Zetasizer was 100.1 nm. The large particle count of the ink >0.56 µm/0.1 mL was 7.8x106 and the count >1.0 µm/0.1 mL was 1.6x10⁴.

### Example 21

Ink 9: An alternative ink to 7, and 8 was made using the same concentrated dispersion as for ink 8 as base for the ink. The final formulation was approximately 7.18 wt% silver-silica particles, 0.36 wt% 29000 MW PVP, 0.10 wt% SURFYNOL^{®} 440, 55.82 wt% glycerol, and 36.54 wt% deionized water. The viscosity of the ink was measured as 10.9 cP by a Brookfield HVDV II+ viscometer at 24.8°C. Surface tension of the ink was 31.92 mN/m at room temp as measured with a Kruss K100 tensiometer using a Wilhelmy plate technique. Ink density was measured as 1.24 g/ml with an ink density cup at room temperature. The pH of the ink was 3.95. The z-average particle size as measured by Malvern Zetasizer was 207.2 nm. The large particle count of the ink >0.56 µm/0.1 mL was 7.4x10⁷ and the count >1.0 µm/0.1 mL was 2.1x10⁷. Particle size data represent data taken after 15 days which indicates aging over time.

### Example 22

Silver-silica particles were modified with hexamethyldisilazane (Dow 6079) to give compatibility with organic solvents. The functionalized particles were then dispersed into methyl ethyl ketone (MEK) at 20 wt% by immersion of bottle into an ultrasonic bath. This produced a dispersion with vehicle compatible for continuous inkjet (CIJ) formulation.

### Example 23

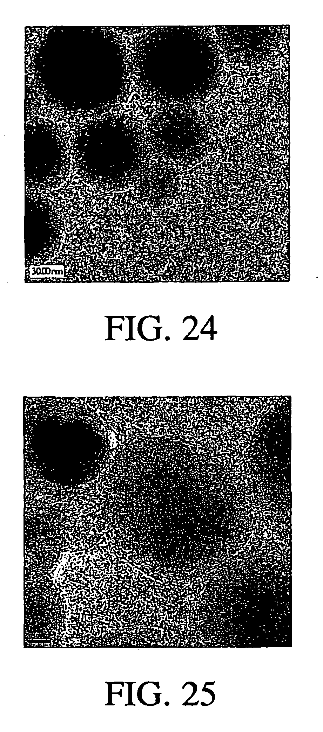

Nano-sized (5-500 nm) glass frit particles were prepared with the following compositions:
Glass A: Bi₂O₃ 55 wt%; B₂O₃ 23 wt%; and ZnO 22 wt%. These particles had an average particle size of 120 nm and were produced by flame spray pyrolysis. A TEM image of glass A is shown in FIG. 24.
Glass B: Bi₂O₃ 80 wt%; B₂O₃ 5 wt%; ZnO 5 wt%; SrO 5 wt%; and SiO₂ 5 wt%. These particles had an average particle size of 110 nm and were produced by flame spray pyrolysis. Silver-metal oxide composites were prepared as follows:
   Composite A: Ag 99 wt%; and SiO₂ 1 wt%;
   Composite B: Ag 99 wt%; and Glass A 1 wt%; and
   Composite C: Ag 99 wt%; and Glass B 1 wt%.

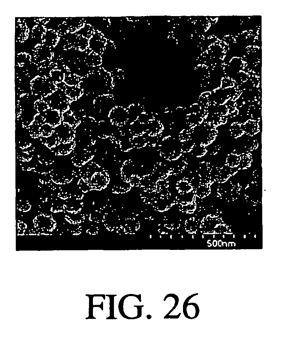

A TEM image of composite A is shown in FIG. 25. A SEM image of composite B nanoparticles is shown in FIG. 26.

### Example 24

Silver pastes for screen printing were prepared as follows:
Paste A: Ag-silica 85 wt%; nano-sized (5-500 nm) glass frit particles 1 wt%; polymeric dispersant (e.g., copolymer of polyether and polycarbonate) 0.05 wt%; and water/ethylene glycol 13.95 wt%. The proportions of water to ethylene glycol were 50/50 wt%.
Paste B: Ag-glass A (or B) 80 wt% + polymeric dispersant 4 wt%; resin (e.g., 20 wt% of ethyl cellulose solution in terpineol) 2 wt%; and paste vehicle 14 wt%. In this case, diethylene glycol monomethyl ether was used as the paste vehicle.

The paste formulations are varied depending on desired paste viscosity.

While the present invention has been described and illustrated by reference to particular embodiments, those of ordinary skill in the art will appreciate that the invention lends itself to variations not necessarily illustrated herein. For this reason, then, reference should be made solely to the appended claims for purposes of determining the true scope of the present invention.

## Claims

1. A process for forming a photovoltaic conductive feature, comprising:
(a) depositing a composition onto at least a portion of a substrate, wherein the composition comprises metal-containing particles having a primary particle size of from about 10 nanometers to less than 500 nanometers, preferably to about 300 nanometers, more preferably to about 200 nanometers and most preferably to about 100 nanometers, and including a continuous or non-continuous coating of a ceramic material, wherein said metal is selected from silver, copper, gold, palladium, platinum, nickel, cobalt, zinc, molybdenum, tungsten, and alloys thereof, or alternatively said metal is selected from ruthenium, titanium, and alloys thereof; and
(b) heating the composition at a temperature comprised between 400 and 1000 °C causing the metal containing particles to sinter and such that the composition forms at least a portion of a photovoltaic conductive feature.

2. The process of claim 1, wherein the size distribution of said particles is such that at least 90 weight percent of the particles have a size of less than 2 µm, preferably of less than 1 µm.

3. The process of claims 1-2, wherein the size distribution of said particles is such that at least 1 weight percent of the particles, preferably at least 5 percent, have a size greater than 1 µm.

4. The process of claims 1-3, wherein the volume ratio of metal to ceramic material for the particles is at least 9:1 1 preferably at least 19:1.

5. The process of claims 1-4, wherein the composition comprises aggregates of a plurality of said metal-containing particles in a matrix of said ceramic material, and wherein said aggregates have a particle size of less than 500 nanometers, preferably of from 75 nanometers to 200 nanometers.

6. The process of claim 5, wherein the aggregates comprise an average of less than 20 of said metal-containing particles per aggregate, preferably of less than 5.

7. The process of claims 1-6, wherein the depositing is selected from the group consisting of lithographic printing, gravure printing, flexo printing, photopatterning printing, drop on demand printing, syringe printing and aerosol jetting.

8. The process of claim 1-7, wherein the composition comprises a dispersant, preferably selected from the group consisting of an ammonium salt or sodium salts of polyacrylic acid; a styrene acrylic polymer; condensed naphthalene sulfonate; polymerized alkyl naphthalene sulfonic acid; a phosphate of an EO-PO-EO block polymer; and an EO-PO- acrylic polymer.

9. The process of claims 1-8, wherein the metal-containing particles are functionalized with one or more functional groups and wherein functional groups preferably comprise a silane or a siloxane.

10. A photovoltaic conductive feature obtainable by the process of claim 1, comprising:
(a) a percolation network of metallic particles in electrical contact with a silicon-containing substrate, the metallic particles comprising a metal selected from silver, copper, gold, palladium, platinum, nickel, cobalt, zinc, molybdenum, tungsten, and alloys thereof, or alternatively selected from ruthenium, titanium, and alloys thereof; and
(b) a ceramic material, in an amount less than 5 wt. %, wherein the percolation network has a resistance that is less than five times the bulk resistance of the metal.

11. The conductive feature of claim 10, wherein the percolation network has a resistance that is less than three times the bulk resistance of the metal.

12. The conductive feature of claims 10-11, wherein the ceramic material comprises an oxide of at least one element selected from lead, strontium, sodium, calcium, bismuth, boron.

13. The conductive feature of claims 10-11, wherein said ceramic material comprises an oxide of at least one element selected from silicon, zinc, zirconium, aluminum, titanium, ruthenium, tin and cerium.

14. The conductive feature of claims 10-11, wherein said metal comprises silver and the ceramic material comprises silica.

15. The conductive feature of claims 10-14, wherein the conductive feature comprises a set of finger lines and collector lines deposited essentially at a right angle to the finger lines, and wherein preferably either or both the parallel finger lines or the collector lines have a width less than 200 µm, preferably less than 100 µm.

16. The conductive feature of claims 10-14, wherein the ceramic material etches a passivating layer on the substrate such that the percolation network forms a continuous electrode structure in direct electrical contact with an emitter layer of the substrate.

17. The process of claim 1, wherein the conductive feature comprises a set of finger lines and collector lines deposited essentially at a right angle to the finger lines, and either or both the parallel finger lines or the collector lines have a width less than 200 µm, preferably less than 100 µm.

18. A process for forming a photovoltaic conductive feature, comprising:
(a) depositing a composition onto at least a portion of a substrate, wherein the composition comprises metal-containing particles having a primary particle size of from about 10 nanometers to less than 500 nanometers, preferably to about 300 nanometers, more preferably to about 200 nanometers and most preferably to about 100 nanometers, and including a continuous or non-continuous coating of a ceramic material, wherein the volume ratio of metal to ceramic material for the particles is at least 9:1 1 preferably at least 19:1; and
(b) heating the composition at a temperature comprised between 400 and 1000 °C causing the metal containing particles to sinter and such that the composition forms at least a portion of a photovoltaic conductive feature.

19. The process of claims 1 and 18, wherein the ceramic material etches a passivating layer on the substrate such that the metal-containing particles form a continuous electrode structure in direct electrical contact with an emitter layer of the substrate.

## Patentansprüche

1. Ein Verfahren zur Bildung eines photovoltaischen leitfähigen Elements, enthaltend:
(a) Aufbringung einer Zusammensetzung auf mindestens einem Teil eines Substrats, worin die Zusammensetzung metallhaltige Partikel mit einer primären Partikelgröße von etwa 10 Nanometern bis zu weniger als 500 Nanometern aufweist, vorzugsweise bis zu etwa 300 Nanometern, noch bevorzugter bis zu etwa 200 Nanometern und am bevorzugtesten bis zu etwa 100 Nanometern, und umfassend eine kontinuierliche oder nicht kontinuierliche Beschichtung eines keramischen Materials, worin besagtes Metall aus Silber, Kupfer, Gold, Palladium, Platin, Nickel, Kobalt, Zink, Molybdän, Wolfram und Legierungen davon ausgewählt wird oder alternativ besagtes Metall aus Ruthenium, Titan und Legierungen davon ausgewählt wird; und
(b) Erwärmen der Zusammensetzung bei einer Temperatur zwischen 400 und 1000°C wobei das Sintern der metallhaltigen Partikel hervorgerufen wird und so dass die Zusammensetzung mindestens einen Teil eines photovoltaischen leitfähigen Elements bildet.

2. Das Verfahren des Anspruchs 1, worin die Größenverteilung besagter Partikel so ist, dass mindestens 90 Gewichtsprozent der Partikel eine Größe von weniger als 2 µm, vorzugsweise weniger als 1 µm aufweisen.

3. Das Verfahren der Ansprüche 1-2, worin die Größenverteilung besagter Partikel so ist, dass mindestens 1 Gewichtsprozent der Partikel, vorzugsweise mindestens 5 Prozent, eine Größe von mehr als 1 µm aufweisen.

4. Das Verfahren der Ansprüche 1-3, worin das Volumenverhältnis von Metall zu keramischem Material für die Partikel mindestens 9:1, vorzugsweise mindestens 19:1 beträgt.

5. Das Verfahren der Ansprüche 1-4, worin die Zusammensetzung Aggregate einer Mehrzahl besagter metallhaltiger Partikel in einer Matrix besagten keramischen Materials enthält und worin besagte Aggregate eine Partikelgröße von weniger als 500 Nanometern, vorzugsweise von 75 Nanometern bis zu 200 Nanometern aufweisen.

6. Das Verfahren des Anspruchs 5, worin die Aggregate ein Mittel von weniger als 20 besagter metallhaltiger Partikel pro Aggregat, vorzugsweise von weniger als 5 aufweisen.

7. Das Verfahren der Ansprüche 1-6, worin die Aufbringung ausgewählt ist aus der aus Lithographiedruck, Tiefdruck, Flexodruck, Lichtmaskendruck, Drop On Demand-Druck, Spritzendruck und Aerosolstrahldruck bestehenden Gruppe.

8. Das Verfahren der Ansprüche 1-7, worin die Zusammensetzung ein Dispergiermittel enthält, vorzugsweise ausgewählt aus der Gruppe bestehend aus einem Ammoniumsalz oder Natriumsalzen von Polyacrylsäure; einem Styrol-Acryl-Polymer; kondensierten Naphthalinsulfonaten, polymerisierter Alkylnaphthalinsulfonsäure; einem Phosphat eines EO-PO-EO-Blockpolymers; und einem EO-PO-Acrylpolymer.

9. Das Verfahren der Ansprüche 1-8, worin die metallhaltigen Partikel mit einer oder mehreren funktionellen Gruppen funktionalisiert sind und worin die funktionellen Gruppen vorzugsweise ein Silan oder ein Siloxan enthalten.

10. Ein photovoltaisches leitfähiges Element erhältlich durch das Verfahren des Anspruchs 1, enthaltend:
(a) ein Perkolationsnetzwerk metallischer Partikel in elektrischem Kontakt mit einem silikonhaltigen Substrat, die metallischen Partikel enthaltend ein Metall ausgewählt aus Silber, Kupfer, Gold, Palladium, Platin, Nickel, Kobalt, Zink, Molybdän, Wolfram und Legierungen davon, oder alternativ ausgewählt aus Ruthenium, Titan und Legierungen davon; und
(b) ein keramisches Material, in einer Menge von weniger als 5 Gew.-%, worin das Perkolationsnetzwerk einen Widerstand hat, der geringer ist als der fünffache Bulk-Widerstand des Metalls.

11. Das leitfähige Element des Anspruchs 10, worin das Perkolationsnetzwerk einen Widerstand aufweist, der geringer ist als der dreifache Bulk-Widerstand des Metalls.

12. Das leitfähige Element der Ansprüche 10-11, worin das keramische Material ein Oxid mindestens eines aus Blei, Strontium, Natrium, Calcium, Bismut, Bor ausgewählten Elements enthält.

13. Das leitfähige Element der Ansprüche 10-11, worin besagtes keramisches Material ein Oxid mindestens eines aus Silizium, Zink, Zirkonium, Aluminium, Titan, Ruthenium, Zinn und Cer ausgewählten Elements enthält.

14. Das leitfähige Element der Ansprüche 10-11, worin besagtes Metall Silber enthält und das keramische Material Siliziumoxid enthält.

15. Das leitfähige Element der Ansprüche 10-14, worin das leitfähige Element einen Satz von Fingerlinien und im Wesentlichen in einem rechten Winkel zu den Fingerlinien aufgebrachten Kollektorlinien enthält und worin vorzugsweise entweder beide die parallelen Fingerlinien oder die Kollektorlinien eine Breite von weniger als 200 µm, vorzugsweise weniger als 100 µm aufweisen.

16. Das leitfähige Element der Ansprüche 10-14, worin das keramische Material eine passivierende Schicht so auf das Substrat ätzt, dass das Perkolationsnetzwerk eine kontinuierliche Elektrodenstruktur in direktem elektrischen Kontakt mit einer Emitterschicht des Substrats bildet.

17. Das Verfahren des Anspruchs 1, worin das leitfähige Element einen Satz von Fingerlinien und im Wesentlichen in einem rechten Winkel zu den Fingerlinien aufgebrachten Kollektorlinien enthält und entweder beide die parallelen Fingerlinien oder die Kollektorlinien eine Breite von weniger als 200 µm, vorzugsweise weniger als 100 µm aufweisen.

18. Ein Verfahren zur Bildung eines photovoltaischen leitfähigen Elements, enthaltend:
(a) Aufbringung einer Zusammensetzung auf mindestens einen Teil eines Substrats, worin die Zusammensetzung metallhaltige Partikel mit einer primären Partikelgröße von etwa 10 Nanometern bis zu weniger als 500 Nanometern, vorzugsweise bis zu etwa 300 Nanometern, noch bevorzugter bis zu etwa 200 Nanometern und am bevorzugtesten bis zu etwa 100 Nanometern enthält und umfassend eine kontinuierliche oder nicht kontinuierliche Beschichtung eines keramischen Materials, worin das Volumenverhältnis von Metall zu keramischem Material für die Partikel mindestens 9:1, vorzugsweise mindestens 19:1 beträgt; und
(b) Erwärmen der Zusammensetzung bei einer Temperatur zwischen 400 und 1000°C, wobei das Sintern der metallhaltigen Partikel hervorgerufen wird und so dass die Zusammensetzung mindestens einen Teil eines photovoltaischen leitfähigen Elements bildet.

19. Das Verfahren der Ansprüche 1 und 18, worin das keramische Material eine passivierende Schicht so auf das Substrat ätzt, dass die metallhaltigen Partikel eine kontinuierliche Elektrodenstruktur in direktem elektrischen Kontakt mit einer Emitterschicht des Substrats bilden.

## Revendications

1. Procédé de formation d'une caractéristique conductrice photovoltaïque, comprenant :
(a) le dépôt d'une composition sur au moins une partie d'un substrat, la composition comprenant des particules à teneur en métal ayant une dimension de particule primaire d'environ 10 nanomètres à moins de 500 nanomètres, de préférence à environ 300 nanomètres, de façon davantage préférée à environ 200 nanomètres et, de la façon que l'on préfère le plus, à environ 100 nanomètres, et comprenant un revêtement continu ou non continu d'une matière céramique, ledit métal étant choisi parmi l'argent, le cuivre, l'or, le palladium, le platine, le nickel, le cobalt, le zinc, le molybdène, le tungstène et leurs alliages, ou, en variante, ledit métal étant choisi parmi le ruthénium, le titane et leurs alliages ; et
(b) le chauffage de la composition à une température comprise entre 400 et 1 000°C, amenant les particules à teneur en métal à fritter et de telle sorte que la composition forme au moins une partie d'une caractéristique conductrice photovoltaïque.

2. Procédé selon la revendication 1, dans lequel la distribution de dimension desdites particules est telle qu'au moins 90 pour cent en poids des particules ont une dimension de moins de 2 µm, de préférence de moins de 1 µm.

3. Procédé selon l'une des revendications 1 et 2, dans lequel la distribution de dimension desdites particules est telle qu'au moins 1 pour cent en poids des particules, de préférence au moins 5 pour cent, ont une dimension supérieure à 1 µm.

4. Procédé selon l'une des revendications 1 à 3, dans lequel le rapport en volume de métal à matière céramique pour les particules est d'au moins 9:1, de préférence d'au moins 19:1.

5. Procédé selon l'une des revendications 1 à 4, dans lequel la composition comprend des agrégats d'une pluralité desdites particules à teneur en métal dans une matrice de ladite matière céramique, et dans lequel lesdits agrégats ont une dimension de particule de moins de 500 nanomètres, de préférence de 75 nanomètres à 200 nanomètres.

6. Procédé selon la revendication 5, dans lequel les agrégats comprennent une moyenne de moins de 20 desdites particules à teneur en métal par agrégat, de préférence de moins de 5.

7. Procédé selon l'une des revendications 1 à 6, dans lequel le dépôt est choisi dans le groupe consistant en l'impression lithographique, l'héliogravure, l'impression flexographique, l'impression par photomodélisation, l'impression par goutte à la demande, l'impression à la seringue et le jet d'aérosol.

8. Procédé selon l'une des revendications 1 à 7, dans lequel la composition comprend un dispersant, de préférence choisi dans le groupe consistant en un sel d'ammonium ou des sels de sodium d'acide polyacrylique ; un polymère styrène acrylique ; du naphtalène sulfonate condensé ; de l'acide alkyl naphtalène sulfonique polymérisé ; un phosphate d'un polymère à blocs EO-PO-EO ; et un polymère EO-PO-acrylique.

9. Procédé selon l'une des revendications 1 à 8, dans lequel les particules à teneur en métal sont fonctionnalisées par un ou plusieurs groupes fonctionnels et dans lequel les groupes fonctionnels comprennent, de préférence, un silane ou un siloxane.

10. Caractéristique conductrice photovoltaïque pouvant être obtenue par le procédé selon la revendication 1, comprenant :
(a) un réseau de percolation de particules métalliques en contact électrique avec un substrat contenant du silicium, les particules métalliques comprenant un métal choisi parmi l'argent, le cuivre, l'or, le palladium, le platine, le nickel, le cobalt, le zinc, le molybdène, le tungstène et leurs alliages, ou en variante, choisies parmi le ruthénium, le titane et leurs alliages ; et
(b) une matière céramique, dans une quantité inférieure à 5 % en poids, le réseau de percolation ayant une résistance qui est de moins de cinq fois la résistance de volume du métal.

11. Caractéristique conductrice selon la revendication 10, dans laquelle le réseau de percolation a une résistance qui est de moins de trois fois la résistance de volume du métal.

12. Caractéristique conductrice selon l'une des revendications 10 et 11, dans laquelle la matière céramique comprend un oxyde d'au moins un élément choisi parmi le plomb, le strontium, le sodium, le calcium, le bismuth, le bore.

13. Caractéristique conductrice selon l'une des revendications 10 et 11, dans laquelle ladite matière céramique comprend un oxyde d'au moins un élément choisi parmi le silicium, le zinc, le zirconium, l'aluminium, le titane, le ruthénium, l'étain et le cérium.

14. Caractéristique conductrice selon l'une des revendications 10 et 11, dans laquelle ledit métal comprend de l'argent et la matière céramique comprend de la silice.

15. Caractéristique conductrice selon l'une des revendications 10 à 14, dans laquelle la caractéristique conductrice comprend un ensemble de lignes digitales et de lignes collectrices déposées sensiblement à un angle droit par rapport aux lignes digitales, et dans laquelle, de préférence, les lignes digitales parallèles et/ou les lignes collectrices ont une largeur inférieure à 200 µm, de préférence inférieure à 100 µm.

16. Caractéristique conductrice selon l'une des revendications 10 à 14, dans laquelle la matière céramique grave une couche de passivation sur le substrat de telle sorte que le réseau de percolation forme une structure d'électrode continue en contact électrique direct avec une couche émettrice du substrat.

17. Procédé selon la revendication 1, dans lequel la caractéristique conductrice comprend un ensemble de lignes digitales et de lignes collectrices déposées sensiblement à un angle droit par rapport aux lignes digitales, et les lignes digitales parallèles et/ou les lignes collectrices ont une largeur inférieure à 200 µm, de préférence inférieure à 100 µm.

18. Procédé de formation d'une caractéristique conductrice photovoltaïque, comprenant :
(a) le dépôt d'une composition sur au moins une partie d'un substrat, la composition comprenant des particules à teneur en métal ayant une dimension de particule primaire d'environ 10 nanomètres à moins de 500 nanomètres, de préférence à environ 300 nanomètres, de façon davantage préférée à environ 200 nanomètres et, de la façon que l'on préfère le plus, à environ 100 nanomètres, et comprenant un revêtement continu ou non continu d'une matière céramique, le rapport en volume de métal à matière céramique pour les particules étant d'au moins 9:1, de préférence d'au moins 19:1 ; et
(b) le chauffage de la composition à une température comprise entre 400 et 1 000°C, amenant les particules à teneur en métal à fritter et telle sorte que la composition forme au moins une partie d'une caractéristique conductrice photovoltaïque.

19. Procédé selon l'une des revendications 1 et 18, dans lequel la matière céramique grave une couche de passivation sur le substrat de telle sorte que les particules à teneur en métal forment une structure d'électrode continue en contact électrique direct avec une couche émettrice du substrat.
